# EUROPEAN PATENT SPECIFICATION

(11) **EP 3 692 582 B1**
(45) Date of publication and mention of the grant of the patent: **26.03.2025**
(21) Application number: 18864538.6
(22) Date of filing: 04.10.2018
(51) Int. Cl.: H10K 30/15, H10K 30/57, H10K 39/12, H10K 85/50, H10K 30/50

(54) **PEROVSKITE DEVICES AND METHODS OF MAKING THE SAME**
PEROWSKIT-VORRICHTUNGEN UND VERFAHREN ZUR HERSTELLUNG DAVON
DISPOSITIFS À PÉROVSKITE ET LEURS PROCÉDÉS DE FABRICATION

(30) Priority: 04.10.2017 US 201762567826 P
(43) Date of publication of application: 12.08.2020
(73) Proprietor: Alliance for Sustainable Energy, LLC, Golden, CO 80401 (US)
(72) Inventor: ZHU, Kai, Littleton Colorado 80127 (US); YANG, Mengjin, Dallasc Texas 75205 (US); KLEIN, Talysa Renae, Bailey Colorado 80421 (US); VAN HEST, Marinus Franciscus Antonius Maria, Lakewood Colorado 80228 (US); LI, Zhen, Shanxi 710072 (CN)
(74) Representative: Secerna LLP
(86) International application number: PCT/US2018/054370
(87) International publication number: WO 2019/070977

(56) References cited:
- WO-A1-2016/186317
- WO-A1-2017/105053
- CN-A- 104 979 477
- US-A1- 2015 122 314
- US-A1- 2017 005 211
- GREEN ET AL.: "The emergence of perovskite solar cells", NATURE PHOTONICS 8.7, vol. 8, no. 7, 27 June 2014 (2014-06-27) - July 2014 (2014-07-01), pages 506 - 514, XP055588390, ISSN: 1749-4885, DOI: 10.1038/nphoton.2014.134
- SFYRI ET AL.: "Study of perovskite solar cells synthesized under ambient conditions and of the performance of small cell modules", SOLAR ENERGY MATERIALS AND SOLAR CELLS, vol. 134, 1 March 2015 (2015-03-01), pages 60 - 63, XP029134952, DOI: doi:10.1016/j.solmat.2014.11.034

## Description

### BACKGROUND

Perovskite materials, for example organic-inorganic halide perovskites, have drawn tremendous attention in recent years as promising candidates for the next generation of low-cost photovoltaics (PV). The power conversion efficiency (PCE) of perovskite solar cells (PSCs) has rapidly surged from <4% to 22.1% (certified), rivaling conventional thin film PV materials, such as CdTe and CIGS. Perovskites' high performance may originate from many of these materials' excellent optoelectronic properties, such as high absorption coefficient, low defect density and defect tolerance, long carrier lifetime, and advantageous diffusion length. More importantly, high performance PSCs can be fabricated through low cost solution processes. Indeed, PSCs are the first solution-processed solar cells that exceed the 20% efficiency benchmark. With continuous improvements in performance, stability and scaling-up of PSCs, their potential to revolutionize the PV industry is becoming more realistic than ever.

Perovskite containing PV devices have been previously described. For example, US 2017/005211 A1 describes an optoelectronic device having a layered construction, specifically comprising a base layer, a first conductive layer on the base layer, a photoactive layer on the first conductive layer and a second conductive layer on the photoactive layer, the conductive layers being in electrical contact with the photoactive layer, wherein the photoactive layer may be a perovskite. WO 2016/186317 A1 describes a perovskite solar cell module, and more particularly, a perovskite solar cell module in which solar cells include a material having a perovskite structure as an absorbing layer. US 2015/122314 A1 also describes an optoelectronic device comprising a porous dielectric scaffold material and a semiconductor in contact with the scaffold material, wherein the semiconductor may be a perovskite.

Despite this progress in cell efficiency, most researches have focused on lab-scale, e.g. small-area devices (<1 cm²), fabricated by spin coating. Thus, there remains significant need for the development of practical manufacturing methods for the full-scale production of large-area solar modules that integrate multiple sub-cells. There exists a gap between the lab-scale small-area devices and the large-area solar modules, as the spin coating process is not designed for uniform coating over large size substrates. Developing scalable deposition processes for scaling up the PSCs are essential for their practical applications and commercial adaption.

### SUMMARY

Disclosed herein but not according to the claimed invention is a perovskite-containing solar cell module that includes a glass substrate; a first cell; and a second cell, where each cell includes, in order, a first contact layer that includes fluorine-doped tin oxide, positioned on the substrate, and having an outside surface and a first thickness; an electron transfer layer that includes TiO₂ and having a second thickness between 1 nm and 10 µm; an active layer that includes the perovskite and having a third thickness; a hole transfer layer that includes spiro-OMeTAD and having a fourth thickness; and a second contact layer that includes copper and having a fifth thickness. In addition, the first cell and the second cell are electrically connected by a first gap filled with the copper, and the first gap passes through the third thickness, the fourth thickness, and substantially through the second thickness to terminate at the outside surface.

An aspect of the present disclosure is a perovskite-containing solar cell module that includes a substrate having a first surface; a first cell; and a second cell, where each cell includes, in order, a first contact layer that includes a first material, positioned on the substrate, and having a second surface and a first thickness; an electron transfer layer (ETL) that includes a second material and having a second thickness of 1 nm - 45 nm; an active layer that includes the perovskite and having a third thickness; a hole transfer layer (HTL) that includes a third material and having a fourth thickness; and a second contact layer that includes a fourth material and having a fifth thickness. In addition, the first cell and the second cell are electrically connected by a first gap filled with the fourth material, and the first gap passes through the third thickness, the fourth thickness, and substantially through the second thickness to terminate at the second surface.

In some embodiments of the present disclosure, the module may further include a second gap filled with the second material, where the second gap passes substantially through the first thickness to terminate at the first surface, and the second gap separates the first contact of the first cell from the first contact of the second cell. In some embodiments of the present disclosure, the module may further include a third gap, where the third gap passes through fourth thickness, the third thickness, and substantially through the second thickness to terminate at the second surface, and the third gap separates the second contact of the first cell from the second contact of the second cell. In some embodiments of the present disclosure, the module may further include an insulating layer that includes a fifth material and positioned on the second contact layer, where the second contact layer is positioned between the insulating layer and the HTL, the insulating layer is not electrically conductive, and the fifth material fills the third gap.

In some embodiments of the present disclosure, the perovskite may be defined by ABX₃, where A is a first cation, B is a second cation, and X is an anion. In some embodiments of the present disclosure, the perovskite may include at least one of MAPbI₃ and/or MAₓFA₁₋ₓPbI₃, wherein x is between zero and one, inclusively. In some embodiments of the present disclosure, the first material may include at least one of a metal nanowire, a carbon nanotube, a transparent conducting oxide, graphene, and/or PEDOT:PSS. In some embodiments of the present disclosure, the second material may include at least one of TiO₂, ZnO, SnO₂, BaSnO₃, and/or SrTiO₃. In some disclosures not according to the claimed invention, the ETL may have a thickness between 5 nm and 10 µm, inclusively.

In some embodiments of the present disclosure, the ETL may include a compact layer and a mesoporous layer, and the compact layer may be positioned between the mesoporous layer and the first contact layer. In some embodiments of the present disclosure, the third material may include at least one of spiro-OMeTAD, PTAA, NiO, CuSCN, CuPc, CuI, a graphene oxide, a carbon nanotube, and/or any suitable organic material. In some embodiments of the present disclosure, the fourth material may include at least one of gold, silver, copper, aluminum, nickel, chromium, a molybdenum oxide, a carbon nanotube, graphene, and/or a transparent conducting oxide. In some embodiments of the present disclosure, the second contact layer may have a thickness between 1 nm and 10 µm, inclusively. In some embodiments of the present disclosure, the fifth material may include a polymer.

Disclosed herein but not claimed is a method for manufacturing a solar cell module, where the method includes a first applying of a first solution of an electron transfer layer (ETL) precursor onto a first surface of a first contact layer having a first thickness, where the first applying results in a first liquid film on the first surface, the first liquid film transforms into the ETL that includes a first solid material and having a second surface, and the first applying is performed using at least one of spin coating, spray coating, blade coating, slot-die coating, inkjet printing, screen printing, electrodeposition, sputtering, evaporation, pulsed laser deposition, chemical vapor deposition, and/or atomic layer deposition. The first applying may be performed by spray coating. The first applying may be performed by spray pyrolysis. During the first applying, the first surface may be at a temperature between 300 °C and 600 °C. The ETL precursor may include titanium diisopropoxide bis(acetylacetonate).

### BRIEF DESCRIPTION OF THE DRAWINGS

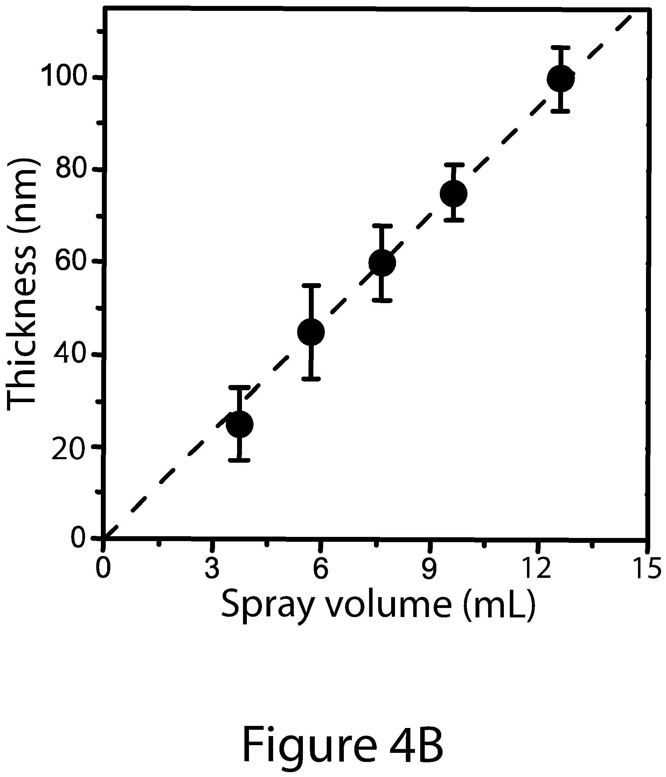

Exemplary embodiments are illustrated in referenced figures of the drawings. It is intended that the embodiments and figures disclosed herein are to be considered illustrative rather than limiting. The devices with layer thicknesses of the electron transfer layer beyond 45 nm as shown in figures 4B, 5A-5F, 8, 13A-13C are reference examples not according to the claimed invention.
Figures 1A, 1B, and 1C illustrate the structure of a perovskite, according to some embodiments of the present disclosure.
Figures 2A and 2B illustrate a non-ideal module and an ideal module, respectively, including at least two cells connected in series, where each cell includes perovskite layer (e.g. an organic-inorganic halide perovskite layer), according to some embodiments of the present disclosure.
Figure 3 illustrates a method for producing a module that approaches the ideal module illustrated in Figure 2B, according to some embodiments of the present disclosure.
Figure 4A illustrates the impact of controlling the spray volume of TiO₂ precursor solution on the TiO₂ layer thickness, according to some embodiments of the present disclosure. Panels (a)-(e) illustrate cross-section SEM images for the compact TiO₂ films coated with different amounts of spray volumes of the TiO₂ precursor solution.
Figure 4B illustrates the scaling behavior of the TiO₂ film thickness with the spray volume of the TiO₂ precursor solution, according to some embodiments of the present disclosure. With this scaling dependence, it is possible to estimate the TiO₂ film thickness that is less than 20 nm and difficult to determine from the SEM images.
Figure 5A illustrates typical photocurrent-voltage (J-V) curves of 4-cell perovskite solar modules as a function of TiO₂ film thickness (electron transport layer or ETL) from about 10 nm to 100 nm, according to some embodiments of the present disclosure. The inset shows a picture of a 4-cell module with ~10.36 cm² aperture area.
Figure 5B illustrates stabilized power outputs (SPO) of the perovskite solar modules of Figure 5A, measured near the maximum power points under continuous one-sun illumination, according to some embodiments of the present disclosure.
Figures 5C-5F illustrate comparisons of the impacts of TiO₂ film thickness on several PV parameters of small cells (~0.1 cm² active area) and 4-cell modules, according to some embodiments of the present disclosure: Figure 5C power conversion efficiency (PCE); Figure 5D short-circuit photocurrent density (*J*_{sc}); Figure 5E fill factor (FF); and Figure 5F open-circuit voltage (*V*_{oc}). In Figures 5D and 5F, the *J*_{sc} and *V*_{oc} values for the 4-cell modules are shown on the per cell basis for comparison purpose.
Figure 6 illustrates a blade-coated perovskite thin film on 1.5" × 2" substrate, according to some embodiments of the present disclosure.
Figure 7 illustrates a microscopy image of typical P1, P2, and P3 patterning lines (gaps), similar to the ideal module shown in Figure 2B, according to some embodiments of the present disclosure. In this example, gap widths of P1 (Reference Number 290), P2 (280), and P3 (270) were about 32 µm, 260 µm, and 62 µm, respectively. The distance between P1 and P3 was about 0.89 mm and the individual cell width was 7 mm, leading to the example module's geometrical fill factor (GFF) of about 87.3%.
Figure 8 the impact of the TiO₂ film thickness (ETL) on the interconnection contact behavior in perovskite solar modules measured under one-sun illumination, for modules approaching the ideal case of Figure 2B, according to some embodiments of the present disclosure.
Figure 9A compares SEM images of blade-coated MAPbI₃ (Panel (a)) and MA_{0.7}FA_{0.3}PbI₃ (Panel (b)) perovskite films, according to some embodiments of the present disclosure.
Figure 9B compares time-resolved photoluminescence (TRPL) lifetime measurements on perovskite thin films, MAPbI₃ and MA_{0.7}FA_{0.3}PbI₃, deposited on glass substrates, according to some embodiments of the present disclosure.
Figure 9C compares the *J*-*V* curves of perovskite thin films, MAPbI₃ and MA_{0.7}FA_{0.3}PbI₃, deposited on glass substrates, for modules approaching the ideal case of Figure 2B, according to some embodiments of the present disclosure.
Figure 9D compares the external quantum efficiency (EQE) spectra of PSCs based on MAPbI₃ and MA_{0.7}FA_{0.3}PbI₃ thin films, for modules approaching the ideal case of Figure 2B, according to some embodiments of the present disclosure.
Figure 10A illustrates an SEM image of the device stack consisting of blade-coated perovskite as well as blade-coated spiro-OMeTAD-based HTL, according to some embodiments of the present disclosure.
Figure 10B illustrates *J*-*V* curves and SPO (inset) of the best four-cell perovskite solar module with ~10.36 cm² aperture area, for modules approaching the ideal case of Figure 2B, according to some embodiments of the present disclosure.
Figure 11 illustrates a top view SEM image of blade-coated spiro-OMeTAD-based hole transport layer, according to some embodiments of the present disclosure.
Figure 12A illustrates a photo of a 6-cell perovskite solar module with an aperture area of 26.04 cm² (4.2 cm × 6.2 cm), for modules approaching the ideal case of Figure 2B, according to some embodiments of the present disclosure.
Figure 12B illustrates a *J*-*V* curve with reverse scan and the stabilized power output under continuous one-sun illumination), according to some embodiments of the present disclosure.
Figures 13A, 13B, and 13C illustrate contact behavior using various top contact materials: Figure 13A Cu in dark and Figure 13B Cu under one sun as well as Figure 13C MoOₓ/Al in dark as the top contact material, according to some embodiments of the present disclosure.

### REFERENCE NUMBERS

- 100: perovskite
- 110: cation A
- 120: cation B
- 130: anion X
- 200: module
- 202: cell
- 204: interconnection
- 210: substrate
- 220: first contact layer
- 230: electron transport layer (ETL)
- 240: perovskite layer
- 250: hole transport layer (HTL)
- 260: second contact layer
- 270: empty gap
- 280: contact layer filled gap
- 290: ETL filled gap
- 300: method
- 310: depositing of a first contact layer
- 312: first intermediate module
- 315: forming of a first gap
- 317: second intermediate module
- 320: depositing of an ETL
- 325: third intermediate module
- 330: depositing of a perovskite layer
- 335: first treating
- 337: fourth intermediate module
- 340: depositing of a HTL
- 342: second treating
- 344: fifth intermediate module
- 345: forming of second gap
- 347: sixth intermediate module
- 350: depositing of second contact layer
- 352: seventh intermediate module
- 355: forming of third gap
- 360: final target module

### DETAILED DESCRIPTION

The present disclosure may address one or more of the problems and deficiencies of the prior art discussed above.

The present disclosure relates to PSCs suitable for full-scale use (e.g. industrial and/or commercial) and methods for manufacturing these PSCs. Large-area PSCs can be separated into smaller area sub-cells, which may then be series interconnected to form a solar module. The solar module integration avoids long distance charge transport in TCO substrates, thus reducing parasitic resistive losses. Solar module integration also increases the photo-voltage available from the modules. There are at least two approaches to constructing a solar module on a monolithic substrate. One is to deposit each functioning layer only onto the needed regions, either through a mask guided deposition or pattern-able printing techniques (e.g. screen printing). Another approach is to coat each layer on the entire substrate area and later separate the sub-cells with laser and/or mechanical scribing. Both methods generate "dead" regions depending on the resolution of the patterning or scribing methods used. The ratio of active area to substrate area is referred to as the geometric fill factor (GFF) of the module, with a higher GFF meaning a smaller dead area power loss due to the module integration. The first approach usually creates wider gap distances between sub-cells due to the lower resolution compared to the gap distances that can be achieved using laser scribing. The wider gap distances may result in erosion of the module's active area and reduced GFF of the modules.

One major difference between large-area solar modules (e.g. full-scale) and small-area single cells (e.g. lab-scale) is the contacts connecting individual sub-cells. Developing procedures to scribe sub-cells and make reliable and effective interconnections between them are of critical importance to fabricate large-scale solar modules with efficiencies as high as those demonstrated in single cells. Thus, the present disclosure demonstrates a fully scalable manufacturing method for perovskite module fabrication. In some embodiments of the present disclosure, a TiO₂ electron transport layer (ETL) may be deposited using spray pyrolysis, with both a perovskite absorber layer and a spiro-OMeTAD hole transport layer (HTL) deposited using blade coating. The influence of TiO₂ ETL thickness on the resistance of metal/TiO₂/TCO interconnections in the resultant perovskite modules are described herein. The optimized ETL thickness to balance shunting and interconnection resistance is identified. With optimizations on the ETL thickness, blade coating HTL, and perovskite composition, an aperture PCE of 15.6% and an aperture area of 10.36 cm² was achieved for a 4-cell perovskite module, with the cells in series, with gaps (the result of scribing) separating the individual cells from one another. This example is among the highest efficiencies of perovskite solar modules fabricated by scalable deposition methods.

The term "spray pyrolysis" refers in general to a process in which thins films may be deposited by spraying a solution containing precursors onto a heated surface, where the precursors react and/or thermally degrade to form the desired films, for example TiO₂. In some embodiments of the present disclosure, the precursors for forming TiO₂ (titanium diisopropoxide bis(acetylacetonate) in a 1-butanol solution) may be sprayed onto a heated substrate (e.g. glass) that is at a temperature between 300 °C and 600 °C, or between 400 °C and 550 °C. Further, the terms "mesoporous" layers and "compact" layers refer to the presence or absence, respectively, of pores in the layers. In some embodiments of the present disclosure, a mesoporous TiO₂ film (e.g. ETL film) may be formed from a plurality of interconnected TiO₂ nanoparticles having a characteristic length between 50 nm and 100 nm, wherein the interconnected nanoparticles also contain interstitial spaces, or pores, resulting in an overall empty volume in the film between 50% and 70%. In contrast, a compact TiO₂ film, formed for example by vapor phase deposition, has an overall empty pore volume equal to zero percent, or approaching zero percent.

Thus, in some embodiments of the present disclosure, one or more layers (e.g. a perovskite layer and/or a HTL) of a solar cell module may be deposited by blade coating. Blade coating may be performed at a speed between 0.05 meters/minute and 1000 m/min, or between 0.25 m/min and 300 m/min. Further, blade coating may be performed at a height between 40 µm and 400 µm, or between 25 µm and 200 µm. In some embodiments of the present disclosure, blade coating may apply a liquid precursor such that the applied liquid film has a wet film thickness between 1 µm and 20 µm, corresponding to a liquid precursor application rate between 1 ml/m² and 20 ml/m², or between 0.1 ml/m² and 50 ml/m².

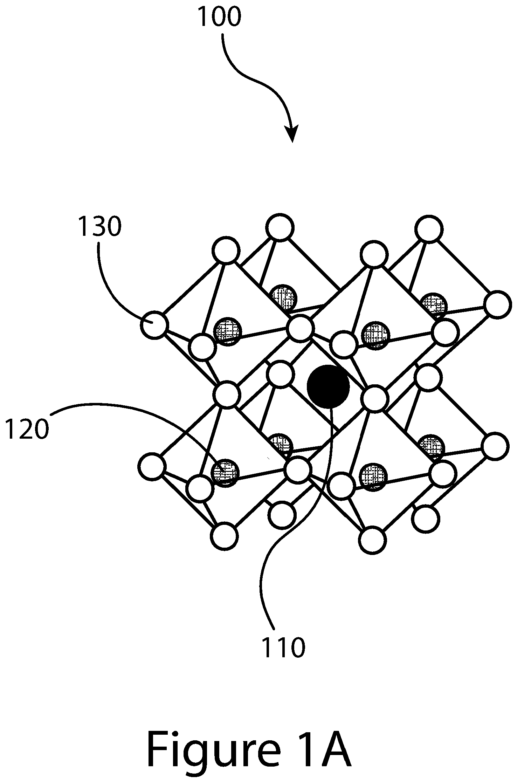

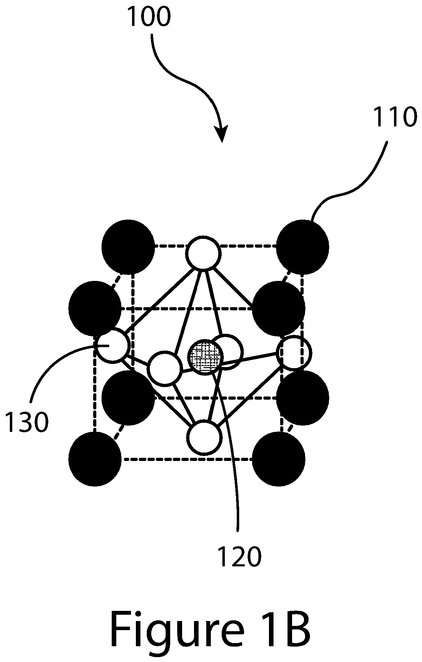

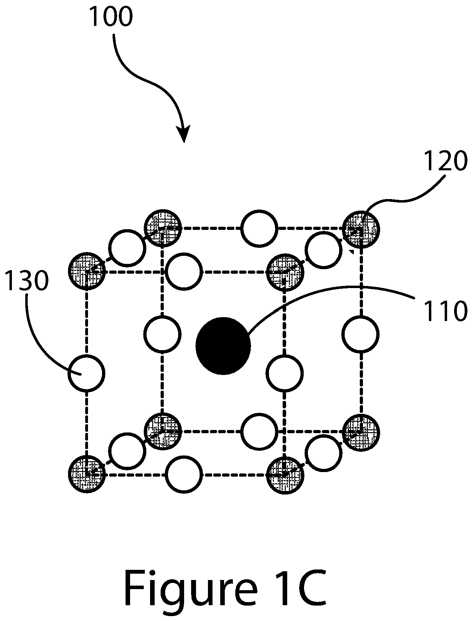

Figures 1A, 1B, and 1C illustrate that perovskites 100, for example organic-inorganic halide perovskites, may organize into cubic crystalline structures with corner-sharing octahedra, as well as other crystalline structures such as tetragonal, hexagonal, and orthorhombic with either edge- or face-sharing octahedra, and may be described by the general formula ABX₃, where X (130) is an anion and A (110) and B (120) are cations, typically of different sizes (A typically larger than B). Figure 1A illustrates that a perovskite 100 may be organized into eight octahedra surrounding a central A-cation 110, where each octahedra is formed by six X-anions 130 surrounding a central B-cation 120. Figure 1B illustrates that a perovskite 100 may be visualized as a cubic unit cell, where the B-cation 120 is positioned at the center of the cube, an A-cation 110 is positioned at each corner of the cube, and an X-anion 130 is face-centered on each face of the cube. Figure 1C illustrates that a perovskite 100 may also be visualized as a cubic unit cell, where the B-cation 120 resides at the eight corners of a cube, while the A-cation 110 is located at the center of the cube and with 12 X-anions centrally located between B-cations along each edge of the unit cell. For both unit cells illustrated in Figures 1B and 1C, the A-cations 110, the B-cations 120, and the X-anions 130 balance to the general formula ABX₃, after accounting for the fractions of each atom shared with neighboring unit cells. For example, referring to Figure 1B, the single B-cation 120 atom is not shared with any of the neighboring unit cells. However, each of the six X-anions 130 is shared between two unit cells, and each of the eight A-cations 110 is shared between eight unit cells. So, for the unit cell shown in Figure 1B, the stoichiometry simplifies to B = 1, A = 8*0.124 = 1, and X = 6*0.5=3, or ABX₃. Similarly, referring again to Figure 1C, since the A-cation is centrally positioned, it is not shared with any of the unit cells neighbors. However, each of the 12 X-anions 130 is shared between four neighboring unit cells, and each of the eight B-cations 120 is shared between eight neighboring unit cells, resulting in A = 1, B = 8 *0.125 = 1, and X = 12*0.25 = 3, or ABX₃. Referring again to Figure 1C, the X-anions 130 and the B-cations 120 are shown as aligned along an axis; e.g. where the angle at the X-anion 130 between two neighboring B-cations 120 is exactly 180 degrees, referred to herein as the tilt angle. However, a perovskite 100 may have may have a tilt angle not equal to 180 degrees. For example, some embodiments of the present disclosure may have a tilt angle between 153 and 180 degrees.

Typical inorganic perovskites include calcium titanium oxide (calcium titanate) minerals such as, for example, CaTiO₃ and SrTiO₃. In some embodiments of the present invention, the A-cation 110 may include a nitrogen-containing organic compound such as an alkyl ammonium compound. The B-cation 120 may include a metal and the X-anion 130 may include a halogen. Additional examples for the A-cation 110 include organic cations and/or inorganic cations, for example Cs, Rb, K, Na, Li, and/or Fr. Organic A-cations 110 may be an alkyl ammonium cation, for example a C₁₋₂₀ alkyl ammonium cation, a C₁₋₆ alkyl ammonium cation, a C₂₋₆ alkyl ammonium cation, a C₁₋₅ alkyl ammonium cation, a C₁₋₄ alkyl ammonium cation, a C₁₋₃ alkyl ammonium cation, a C₁₋₂ alkyl ammonium cation, and/or a C₁ alkyl ammonium cation. Further examples of organic A-cations 110 include methylammonium (CH₃NH³⁺), ethylammonium (CH₃CH₂NH³⁺), propylammonium (CH₃CH₂ CH₂NH³⁺), butylammonium (CH₃CH₂ CH₂ CH₂NH³⁺), formamidinium (NH₂CH=NH²⁺), hydrazinium, acetylammonium, dimethylammonium, imidazolium, guanidinium and/or any other suitable nitrogen-containing or organic compound. In other examples, an A-cation 110 may include an alkylamine. Thus, an A-cation 110 may include an organic component with one or more amine groups. For example, an A-cation 110 may be an alkyl diamine halide such as formamidinium (CH(NH₂)₂). Thus, the A-cation 110 may include an organic constituent in combination with a nitrogen constituent. In some cases, the organic constituent may be an alkyl group such as straight-chain or branched saturated hydrocarbon group having from 1 to 20 carbon atoms. In some embodiments, an alkyl group may have from 1 to 6 carbon atoms. Examples of alkyl groups include methyl (C₁), ethyl (C₂), n-propyl (C₃), isopropyl (C₃), n-butyl (C₄), tert-butyl (C₄), sec-butyl (C₄), iso-butyl (C₄), n-pentyl (C₅), 3-pentanyl (C₅), amyl (C₅), neopentyl (C₅), 3-methyl-2-butanyl (C₅), tertiary amyl (C₅), and n-hexyl (C₆). Additional examples of alkyl groups include n-heptyl (C₇), n-octyl (C₈) and the like.

Examples of metal B-cations 120 include, for example, lead, tin, germanium, and or any other 2+ valence state metal that can charge-balance the perovskite 100. Further examples include transition metals in the 2+ state such as Mn, Mg, Zn, Cd, and/or lanthanides such as Eu. B-cations may also include elements in the 3+ valence state, as described below, including for example, Bi, La, and/or Y. Examples for X-anions 130 include halogens: e.g. fluorine, chlorine, bromine, iodine and/or astatine. In some cases, a perovskite may include more than one X-anion 130, for example pairs of halogens; chlorine and iodine, bromine and iodine, and/or any other suitable pairing of halogens. In other cases, the perovskite halide 100 may include two or more halogens of fluorine, chlorine, bromine, iodine, and/or astatine.

Thus, the A-cation 110, the B-cations 120, and X-anion 130 may be selected within the general formula of ABX₃ to produce a wide variety of perovskites 100, including, for example, methylammonium lead triiodide (CH₃NH₃PbI₃), and mixed halide perovskites such as CH₃NH₃PbI_{3-*x*}Cl*ₓ* and CH₃NH₃PbI_{3-*x*}Br*ₓ*. Thus, a perovskite 100 may have more than one halogen element, where the various halogen elements are present in non-integer quantities; e.g. x is not equal to 1, 2, or 3. In addition, perovskites can form three-dimensional (3-D), two-dimensional (2-D), one-dimensional (1-D) or zero-dimensional (0-D) networks, possessing the same unit structure. As described herein, the A-cation 110 of a perovskite 100, may include one or more A-cations, for example, one or more of cesium, FA, MA, etc. Similarly, the B-cation 120 of a perovskite 100, may include one or more B-cations, for example, one or more of lead, tin, germanium, etc. Similarly, the anion 130 of a perovskite 100 may include one or more anions, for example, one or more halogens. Any combination is possible provided that the charges balance.

For example, a perovskite having the basic crystal structure illustrated in Figure 1A, in at least one of a cubic, orthorhombic, and/or tetragonal structure, may have other compositions resulting from the combination of the cations having various valence states in addition to the 2+ state and/or 1+ state described above for lead and alkyl ammonium cations; e.g. compositions other than AB²⁺X₃ (where A is one or more cations, or for a mixed perovskite where A is two or more cations). Thus, the methods described herein may be utilized to create novel mixed cation materials having the composition of a double perovskite (elpasolites), A₂B¹⁺B³⁺X₆, with an example of such a composition being Cs₂BiAgCl₆ and Cs₂CuBiI₆. Another example of a composition covered within the scope of the present disclosure is described by A₂B⁴⁺X₆, for example Cs₂PbI₆ and Cs₂SnI₆. Yet another example is described by A₃B₂³⁺X₉, for example Cs₃Sb₂I₉. For each of these examples, A is one or more cations, or for a mixed perovskite, A is two or more cations.

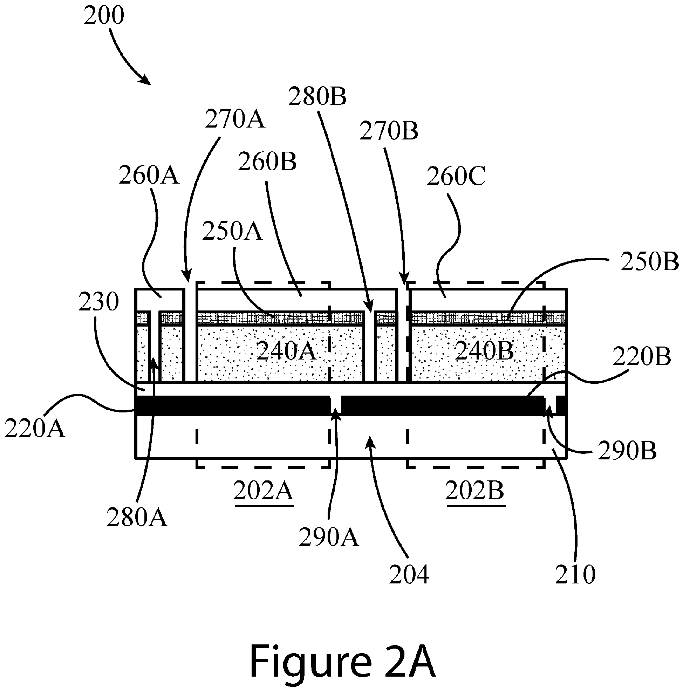

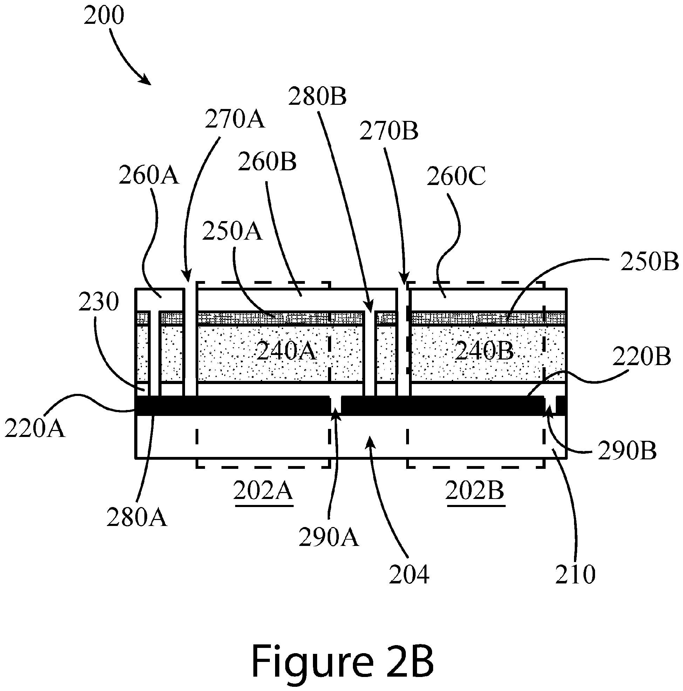

Figures 2A and 2B illustrate non-ideal and ideal perovskite-containing modules 200, respectively. Referring to Figure 2B, an ideal module 200 may include two or more cells (two shown; 202A and 202B) connected in series by an interconnection 204. An interconnection 204 is a physical connection between the second contact layer (e.g. 260B) of a first cell (e.g. 202A) with the first contact layer (e.g. 220B) of a second cell (e.g. 202B). This results in the addition of the voltage produced by each cell (202A and 202B) in the series of cells in the module 200, with the current flowing through each cell remaining constant.

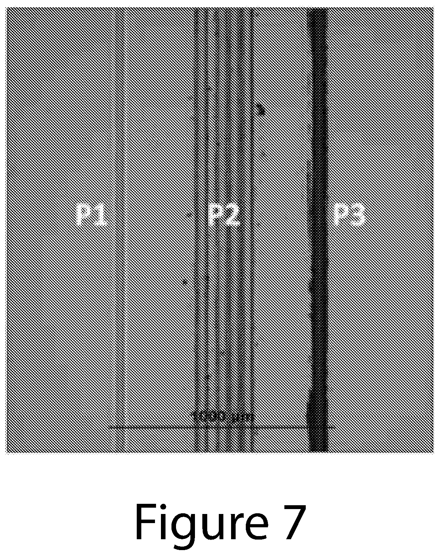

Each cell (202A and 202B) may be positioned on a substrate 210. The substrate 210 may be constructed of any suitable material including at least one of glass, foil and/or plastic. A substrate 210 may have a thickness between several micrometers and several millimeters. A first contact layer 220, for example a transparent conducting oxide (TCO) layer, may be positioned in direct physical contact with the substrate 210. TCOs may include at least one of fluorine-doped tin oxide (FTO), indium-doped tin oxide (ITO), indium zinc oxide (IZO), gallium zinc oxide (GZO), and/or aluminum-doped zinc oxide (AZO). In some embodiments of the present disclosure, a transparent first contact layer 220 may be in the form of at least one of a metal nanowire, a carbon nanotube, a p-type transparent conducting layer, a CuS-based TCO, PEDOT:PSS, and/or a graphene sheet. Gaps (270, 280, and 290) may separate the first contact layer 220 into different sections (e.g. 220A and 220B) corresponding to TCO sections for each respective cell. Each gap (270, 280, and 290) may have a width between about 1 µm and about 1 mm, or between about 5 µm to 250 µm. The module 200 may also include an electron transport layer (ETL) 230 positioned in contact with the first contact layer 220 (e.g. a TCO), such that the first contact layer 220 may be positioned between the substrate 210 and the ETL 230. The ETL 230 shown in Figure 2B may also fill in the gaps, resulting in the ETL filled gaps (290A and 290B; corresponding to P1 in Figure 7), where the ETL material extends through the thickness of the first contact layer 220 from the plane occupied by the ETL 230 to the surface of the underlying substrate 210. Referring to the portion of HTL 250 and perovskite layer 240 positioned between the contact layer filled gap 280B and empty gap 270B, this material does not produce any power. Therefore, it is desirable to minimize the width of this material to as small as possible, e.g. approaching zero nanometers.

In disclosures provided herein but not according to the claimed invention, an ETL 230 may be constructed of at least one of TiO₂, ZnO, SnO₂, BaSnO₃, and/or SrTiO₃, having a thickness between about 5 nm and about 1 µm. In some embodiments of the present disclosure, an ETL 230 may include a first compact layer of these materials and a second mesoporous layer of these materials. Each cell (202A and 202B) of the module 200 may contain a perovskite layer 240, for example an organic-inorganic halide perovskite, as an active layer. So, each cell (202A and 202B) may have its own respective perovskite layer (240A and 240B), positioned in direct physical contact with the underlying ETL 230. The perovskite layer 240 may be constructed of any suitable perovskite having a crystal structure as illustrated in Figures 1A - 1C and described above.

The ideal example of a module 200, shown in Figure 2B, may also include a hole transport layer (HTL) 250 positioned in direct physical contact with the perovskite layer 240, such that the perovskite layer 240 may be positioned between the HTL 250 and the ETL 230. The HTL 230 may be constructed of at least one of spiro-OMeTAD, PTAA, NiO, CuSCN, CuPc, graphene oxide, carbon nanotubes, CuI, and/or an organic material having a thickness between about 5 nm and about 1 µm. As shown in Figure 2B, the perovskite layer 240 and the HTL 250 may be processed to form gaps that separate each into distinct sections for each cell (202A and 202B). So, the perovskite layer 240 may be separated into a first perovskite layer 240A for the first cell 202A and a second perovskite layer 240B for the second cell 202B by at least one gap, where both cells are positioned substantially within the same horizontal plane.

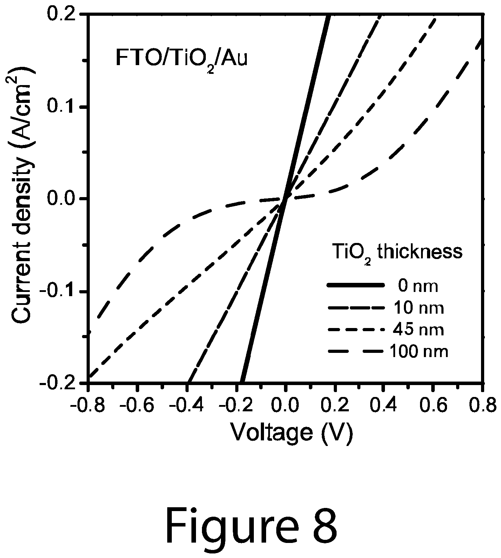

Finally, the ideal module 200, as shown in Figure 2B, may include a second contact layer 260 positioned in direct physical contact with the HTL 250. The second contact layer 260 may be constructed of any suitable metal and/or conductive oxide, with examples including at least one of gold, Ag, MoOx/Al, Cu, carbon nanotube, graphene, Ni, Cr₂O₃/Cr, and/or TCO, having a thickness between about 1 nm and about 10 µm, or between about 5 nm and about 1 µm. The contact layer 260 may fill in the gaps separating the perovskite layer 240 into different sections (e.g. 240A and 240B), resulting in contact layer filled gaps (280A and 280B). In some embodiments, the contact layer filled gaps (280A and 280B, corresponding to P2 in Figure 7) may pass perpendicularly through the thickness of the perovskite layer 240 and the thickness of the ETL 230, such that the contact layer filled gaps (280A and 280B) extend from the plane of the second contact layer 260 to the surface of the underlying first contact layer 220. This is beneficial because removal of the ETL 230 enables direct electrical contact of the first contact layer 220 with the second contact layer 260. Otherwise, any remaining ETL material can form a Schottky contact having large contact resistances (see Figure 8, which demonstrates that as an ETL 230 of TiO₂ thickness is reduced from 100 nm to 10 nm, the I-V curves changed from a Schottky diode behavior (S-shape) to an ohmic behavior (straight line)). Lastly, the ideal module 200 of Figure 2B may include at least one empty gap (270A and 270B corresponding to P3 in Figure 7), which traverses perpendicularly across the entire thicknesses of the second contact layer 260 and the HTL 250, and across the perovskite layer 240. Additionally, the empty gaps (270A and 270B ) may be filled with an insulating material (not shown) to add structural integrity and environmental protection to the thin film device layers. Referring no to the non-ideal module 200 of Figure 2A, this module does not have contact layer filled gaps 280, or empty gaps 270 that extend all the way through the HTL 250, the perovskite layer 240, and the ETL 230, to the surface of the underlying first contact layer 220.

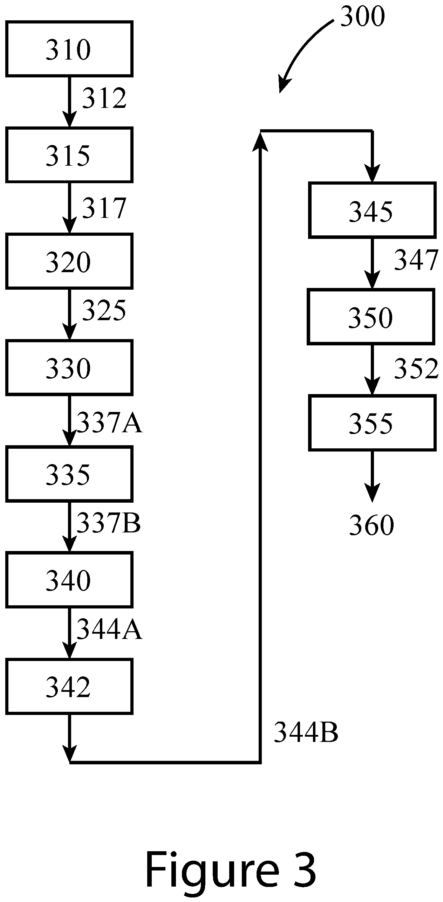

Figure 3 illustrates an example of a method 300 for producing a module 200 like the modules 200 shown in Figures 2A and 2B, with the objective of producing the ideal module 200 of Figure 2B. The method 300 of this example sequentially produces a module, where the module passes through various intermediate incomplete forms. These intermediate forms are referred to herein as "intermediate modules". The method 300 may begin with the depositing of a first contact layer 310 (e.g. TCO layer) onto a substrate, resulting in a first intermediate module 312. The depositing of the TCO layer 310 may include at least one of radio frequency sputtering, direct current sputtering, evaporation, and/or spray pyrolysis. The first intermediate module 312 having a first contact layer 220 on a substrate 210 may then be further processed by the forming of a first gap 315 (ETL filled gap 290 of Figure 2A; P1 of Figure 7) onto the surface of the first contact layer 220; e.g. by patterning using laser scribing, mechanical etching, and/or chemical etching. Thus, the forming of the first gap 315 may result in a second intermediate module 317 having a patterned first contact layer 220, having one or more first gaps. The second intermediate module 317 may then be processed by the depositing of an ETL 310 onto at least a portion of the first contact layer 220, resulting in the formation of a third intermediate module 325. The depositing of the ETL 320 may be achieved by at least one of spin coating, spray coating, blade coating, slot-die coating, inkjet printing, screen printing, electrodeposition, sputtering, evaporation, PLD, CVD, and/or ALD, at a temperature between about room temperature and about 600°C. During the depositing of the ETL 320, at least some of the first gaps formed during the forming of the first gap 315 may be filled with the ETL 230, resulting in ETL filled gaps 290, such that the ETL 230 penetrates the depth of the first gaps to pass completely pass through the thickness of the first contact layer 220 and physically contact the underlying substrate 210.

Referring again to Figure 3, the method 300 may then continue with the depositing of a perovskite layer 330 onto the surface of the ETL, resulting in the formation of a fourth intermediate module 337. The depositing of the perovskite layer 330 may be accomplished by a solution processing method, with examples including at least one of spraying, blade coating, curtain coating, dip coating, spin coating, slot-die coating, inkjet printing, screen printing, electrodeposition, evaporation, and/or CVD, at a temperature between about room temperature and about 350°C. The depositing of the perovskite layer 330 may result in a liquid perovskite layer positioned on the ETL 290 and a fourth intermediate module 337A having a liquid layer positioned on its surface. Thus, the liquid perovskite layer, and the fourth intermediate module 337A, may undergo a first treating 335 to convert the liquid perovskite layer to a solid perovskite layer; e.g. by thermal annealing, at a temperature between about room temperature and about 350°C, at a duration between about 10 seconds and about 100 minutes. As a result, the first treating 335 may result in the conversion of the liquid phase perovskite of the fourth intermediate module 337A to a fourth intermediate module 337B having a solid perovskite layer 240 positioned on the ETL.

Referring again to Figure 3, the fourth intermediate module 337B having a solid perovskite layer 240 may then be processed further by the depositing of a HTL 340 onto the perovskite layer 240. The depositing of the HTL 340 may be accomplished by a solution processing method, with examples including at least one of spraying, blade coating, curtain coating, dip coating, spin coating, slot-die coating, inkjet printing, screen printing, sputtering, evaporation, PLD, CVD, and/or ALD, at a temperature between about room temperature and about 350°C. Like the depositing of a perovskite layer 330, the depositing of the HTL 340 may result in the formation of a fifth intermediate module 344A having a liquid HTL positioned on the perovskite layer. Thus, and the fifth intermediate module 344A having a liquid phase HTL, may undergo a second treating 342 to convert the liquid HTL to a solid HTL 250, resulting in fifth intermediate module 344B; e.g. by thermal annealing at a temperature between about room temperature and about 350°C, at a duration between about 10 seconds and about 100 minutes. As a result, the second treating 342 may result in the formation of a fifth intermediate module 344B having a solid HTL 250 positioned on the solid perovskite layer 240. In some embodiments of the present disclosure, only one treating step may be used to simultaneously convert both a liquid perovskite layer and a liquid HTL to solid forms of each, 240 and 250, respectively.

The fifth intermediate module, having a HTL 250, may then be processed by the forming of a second gap 345 onto the surface of the HTL 250; e.g. patterning by laser scribing, mechanical etching, and/or chemical etching. Thus, the forming of the second gap 345 may result in a sixth intermediate module 347 having a patterned HTL 250, having one or more second gaps. The patterning may completely penetrate the thickness of the HTL 250, the thickness of the underlying perovskite layer 240, and the thickness of the underlying ETL 230. Subsequent to the forming of the second gap 345, the sixth intermediate module 347 having a patterned HTL surface may be processed by the depositing of a second contact layer 350 onto the patterned surface of the HTL 250. The depositing of the second contact layer 350 may be accomplished by at least one of thermal evaporation, spin coating, spray coating, blade coating, slot-die coating, inkjet printing, screen printing, sputtering, PLD, CVD, and/or ALD, at a temperature between about room temperature and about 350°C, resulting in the forming of a seventh intermediate module 352. The second contact layer 260 may completely fill the second gaps, resulting in the ETL filled gaps 290 shown in Figure 2B, such that the second contact layer 260 is in in direct physical contact with the first contact layer 220.

Finally, the method 300 may conclude with the forming of a third gap 355 (the empty gap 270 of Figure 2B) onto the seventh intermediate module 352, resulting in a completed final module 360, similar to that shown in Figure 2B. The third gap, may completely penetrate the thicknesses of each of the second contact layer 260, the HTL 250, the perovskite layer 240, and the ETL 230, such that the third gap passes through the module 200 to the surface of the first contact layer 220. In some embodiments of the present disclosure, the forming of the third gap 355 may be accomplished by laser scribing, mechanical etching, and/or chemical etching. Thus, the forming of the third gap 345 may result in the final module 360 having a patterned contact layer, having one or more third gaps.

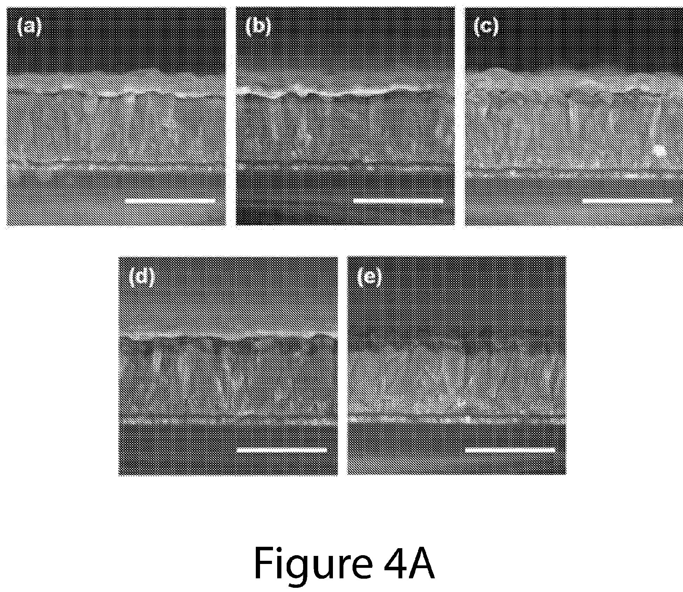

In some embodiments of the present disclosure, a (n-i-p) PSC architecture includes a stack of device layers glass/TCO/ETL/perovskite/HTL/metal, corresponding to substrate/first contact layer/ETL/perovskite layer/HTL/second contact layer. The ETL and the HTL may be constructed of TiO₂ and doped spiro-OMeTAD, respectively. The physical properties of the TiO₂ ETL (e.g., thickness, roughness, porosity, and conductivity) may strongly influence the device performance as well as the hysteresis behavior largely due to the effects of the ETL on the kinetics of electron extraction. In general, an ETL should be pinhole free to minimize shunting and to enable selective/effective extraction and conduction of electrons away from the perovskite layer. The ETL thickness may need to be optimized for high-efficiency PSCs. In some embodiments of the present disclosure, spray-pyrolysis coating may be used to deposit compact TiO₂ (c-TiO₂) ETLs onto a device. In some disclosures provided herein but not claimed, the thickness of a TiO₂ layer (between 1 nm and 100 nm) may be defined by controlling at least one of the number of coating cycles, the rate of spraying, the concentration of the TiO₂ precursor, and/or the total spray volume of the TiO₂ precursor (see Figures 4A and 4B). Described herein, are the impacts of the TiO₂ ETL layer on the characteristics of perovskite-containing modules prepared by blade coating methods using a perovskite ink. In some embodiments of the present disclosure, the ETL precursor (e.g. TiO₂ precursor) may be deposited (e.g. sprayed) onto a surface of a module (e.g. the surface of the first contact layer) at a rate between 0.005 ml/cm² to 0.5 ml/cm².

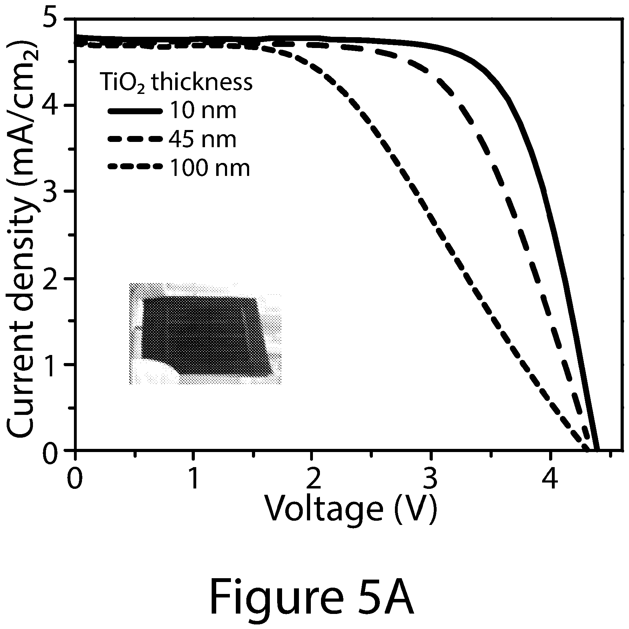

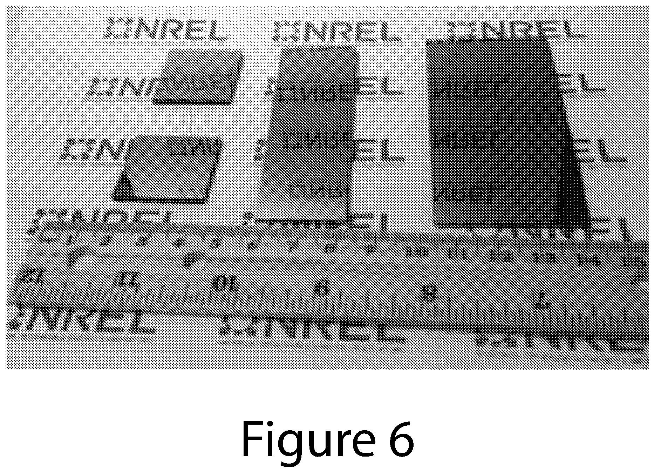

Figure 5A shows the photocurrent-voltage (*J*-*V*) curves of MAPbI₃ perovskite modules having four individual cells series connected on a monolithic substrate. The modules were prepared using a liquid perovskite precursor composition and blade coating process. In some embodiments of the coating process, blade coating was performed on a Zehntner-Automatic film applicator coater using Zehntner ZUA 2000 blade at room temperature. The gap between the blade and the top substrate was fixed at 130 µm and the speed of coating was 5 mm/s. Once the precursor ink was dispensed on to the substrate by blade coating, the substrate was transferred into a diethyl ether bath for solvent extraction, after about 1 minute of drying. A perovskite film crystalized in the ether bath in about 1 minute. Further thermal annealing was conducted after the bath at 150°C for about one to two minutes. Examples of the resultant blade-coated films are shown in Figure 6. These modules have a device structure of FTO/c-TiO₂/perovskite/doped Spiro-OMeTAD/gold (corresponding to first contact layer/ETL/perovskite layer/HTL/second contact layer), with spiro-OMeTAD deposited by spin coating and a gold electrode deposited by thermal evaporation. Scribing was used to form gaps (e.g. P1 - Reference number 290; P2 - 280; and P3 - 270 referring to Figure 7 and Figure 2B, respectively) to isolate and form interconnections between individual cells to complete the manufacture of the module on single substrate. A picture of the typical 4-cell mini-module is shown in the inset of Figure 5A; the aperture area of this example module was about 10.36 cm². Optical microscopy images of typical P1, P2, and P3 scribing lines (gaps) are shown in Figure 7, from which the geometrical fill factor or GFF of the module was estimated to be about 87.3%. The J-V curves (reverse scan) indicate that as the TiO₂ film (ETL) thickness was increased from 10 nm to 100 nm, the fill factor (FF) (where FF is defined as the maximum power point dived by the product of V_{OC} and I_{SC}) decreased significantly from about 0.720 to 0.465, without significant changes in the short-circuit current density (*J*_{sc}) and open-circuit voltage (*V*_{oc}), leading to the aperture PCE dropped from about 15.14% to 9.42%. Because these modules display moderate hysteresis-which will be discussed later- the stabilized power output (SPO) measurement under continuous one-sun illumination was also evaluated. Consistent with the PCE measured at *J*-*V* scans, the SPO efficiency also decreased from 14.7% to 8.6% when the TiO₂ film thickness was increased from about 10 nm to 100 nm. It is worth noting that the SPO efficiency was closer to the PCE resulting from the reverse scan *J*-*V* curves. The detailed *J*-*V* parameters along with SPO values are shown in Table 1.

**Table 1. Effect of TiO₂ film (ETL) thickness on the PV parameters of 4-cell perovskite mini-modules (aperture area ~10.36 cm²) under one-sun illumination. The example with a TiO₂ film thickness of 100 nm is not according to the invention and for reference purpose only.**

| **TiO₂ film (nm)** | ***J*_{sc} (mA/cm²)** | ***V*_{oc} (V)** | **FF** | **PCE (%)** | **SPO (%)** |
|---|---|---|---|---|---|
| 10 | 4.80 | 4.381 | 0.720 | 15.14 | 14.7 |
| 45 | 4.73 | 4.338 | 0.639 | 13.12 | 12.3 |
| 100 | 4.71 | 4.303 | 0.465 | 9.42 | 8.6 |

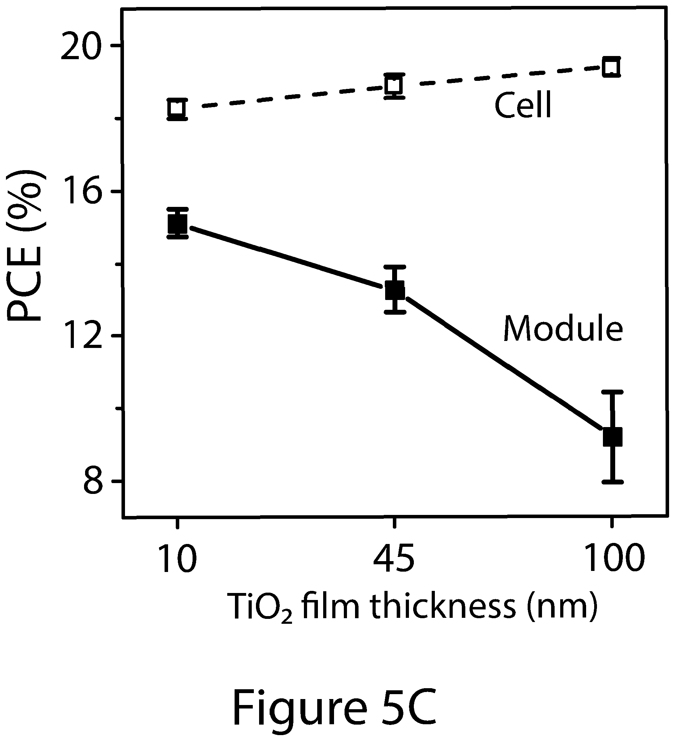

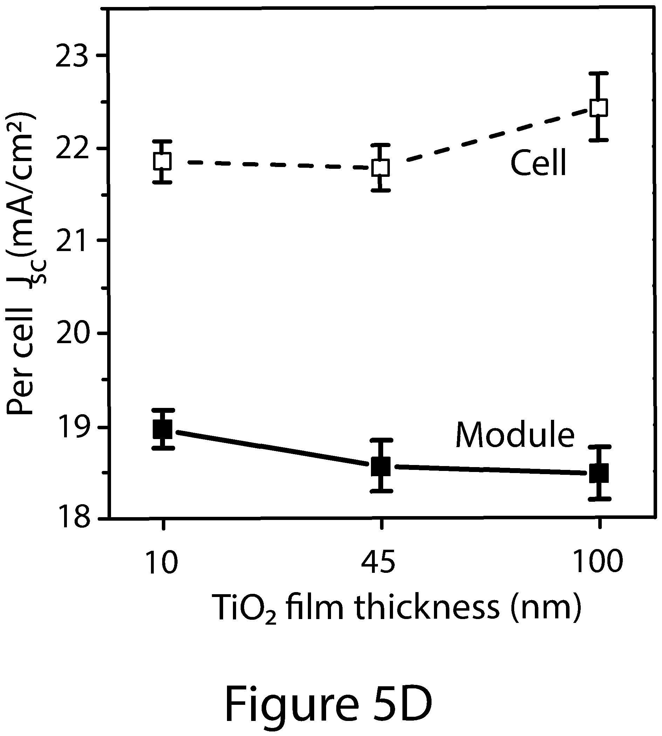

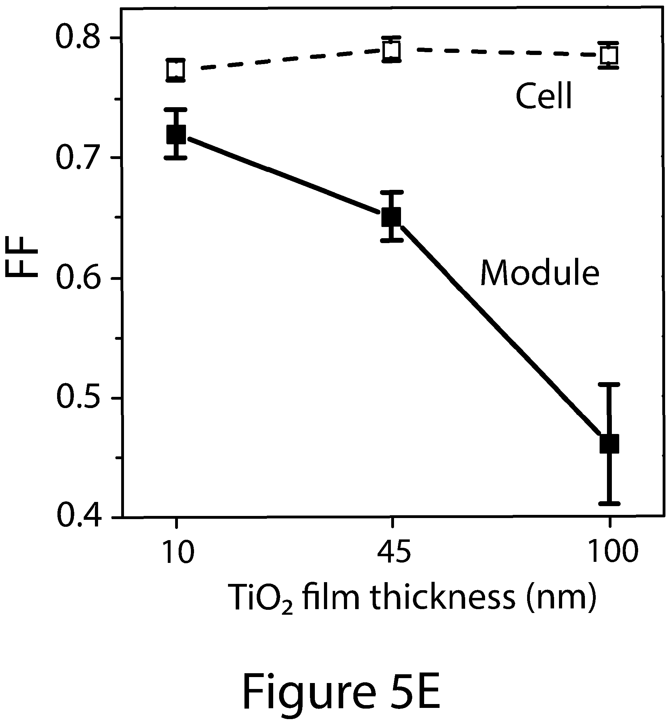

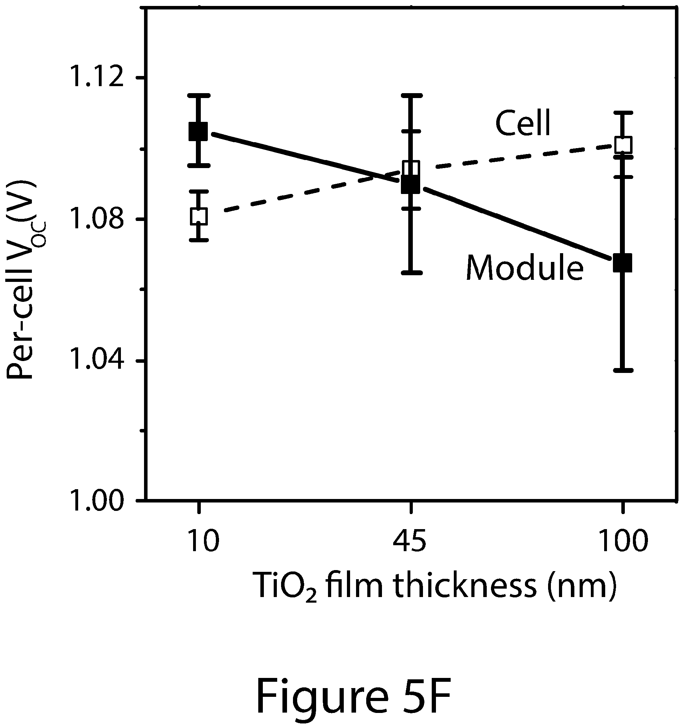

The TiO₂ (ETL) film thickness significantly affected PV performances, with large differences in performances evident between the larger perovskite modules and the smaller lab-scale devices (~0.1 cm² active area). The statistics of PV parameters for both modules and smaller-area devices (cells) are compared in Figures 5C, 5D, 5E, and 5F. For the purpose of comparison, the *J*_{sc} and *V*_{oc} values for the modules are shown on a per-cell basis. When the c-TiO₂ layer thickness was increased from about 10 nm to 100 nm, the PCE of the lab-scale devices improved from about 18.3% to 19.4%, which is mainly attributed to the increased *J*_{sc} and *V*_{oc}. In comparison to lab-scale devices, the *J*_{sc} of mini-modules was significantly lower, which may be attributed to the GFF of 87.3% corresponding to about 12.7% dead area resulting from the module interconnections. The *V*_{oc} values were comparable between the lab-scale devices and the larger modules. The biggest difference was the FF, which stayed almost unchanged around 0.77-0.79 for the lab-scale devices but decreased substantially from 0.72 to 0.46 when the c-TiO₂ film (ETL) thickness was increased from about 10 nm to 100 nm. This suggests that different factors need to be taken into consideration for device optimization when transitioning from smaller-area lab-scale cells to larger surface area modules, even when the same stack layers are used in both types of devices.

To understand the different TiO₂ ETL thickness dependence between smaller-area cells and larger area modules, it is necessary to examine how the perovskite modules are constructed in comparison to the standard process of constructing smaller-area devices. Referring again to Figures 2A and 2B, which show the schematics of a module 200 having an n-i-p architecture. Such a perovskite solar module 200 may include individual cells (e.g. 202A and 202B) serially interconnected on the same substrate 210. In some embodiments of the present disclosure, three scribing processes (P1, P2 and P3) may be needed to complete a module, corresponding to an ETL filled gap 290, a contact layer filled gap 280, and an empty gap 270, respectively. Each ETL filled gap may separate the first contact layer 220A of the first cell 202A from the first contact layer of the adjacent cell; e.g. first contact layer 220B of second cell 202B. Each contact layer filled gap 280 passing through the perovskite layer 240 enables the electrical connection of the first contact layer 220 with the second contact layer 260 of adjacent sub-cells (202A and 202B); each empty gap 270 may separate the second contact layer 260A of a first cell 202A from the second contact layer 260B of its adjacent second cell 202B. In a preferred situation, as shown in Figure 2B, each contact layer filled gap 280 should scribe all the way through the electron transfer layer 230 to the top surface of the underlying first contact layer 220. Subsequent deposition of a second contact layer 260 (e.g., Au) may make direct contact with the first contact layer 220, forming the interconnections 204 between neighboring cells (202A and 202B). However, the TiO₂ ETL layer 230 may exhibit similar material hardness and optical properties as the underlying first contact layer 220 (e.g., FTO), which can present a challenge for both mechanical scribing and laser scribing for removing the oxide layer, without damaging the underlying TCO layer. Such a challenge may be similar for other oxides (e.g., ZnO and SnO₂) that may be used as ETLs in perovskite devices. Thus, in practice, a non-ideal interconnection in n-i-p perovskite modules may exists, where the second contact layer 260 is connected to the first contact layer 220 through a portion of the ETL 230 (see Figure 2A). Because a module 200 includes multiple cells (e.g. 202A and 202B) with interconnections 204 and a large photocurrent is concentrated at the relatively narrow interconnections 204, the contact behavior at these interconnections becomes important to the operation of perovskite modules. In contrast, such interconnection 204 issues do not exist in small-area lab-scale devices.

Figure 8 illustrates the contact behavior of FTO/TiO₂/Au only (no perovskite layer, HTL, etc.), which represents the actual materials of the interconnects used and tested in the perovskite module. These curves were generated by applying a voltage sweep of the FTO/TiO₂/Au and FTO/Au devices. The measurements were done under one-sun illumination through the glass side, mimicking the actual operating conditions of perovskite modules. The contact shows a clear diode rectification behavior when the TiO₂ (ETL) thickness was about 100 nm. This diode behavior changed to a resistive (ohmic) behavior as the TiO₂ film (ETL) thickness was reduced to about 10 nm. All of these interconnection contact resistances contributed to the series resistance of the module, leading to significant parasitic loss and contact voltage loss especially in view of a large current flowing through the multiple interconnection contacts within the module. Such parasitic and voltage loss is expected to strongly affect the FF and *V*_{oc} of the modules as observed in Figures 5E and 5F, respectively.

PSCs may be based on a n-i-p device stack and/or on a p-i-n (inverted) device stack with either planar or mesoporous TiO₂ ETLs deposited on TCOs. Other oxides such as ZnO and NiO may also be used in either normal or inverted module structures. These oxides materials normally exhibit material hardness and optical property similar to the TCO substrates such as FTO and ITO. This presents a challenge for mechanical scribing or laser scribing for removing these materials due to the potential for damaging the underlying first contact layer 220 during the P2 scribing processing. The results presented herein suggest that any residual ETL, in this case an oxide layer, remaining after the P2 scribing may cause parasitic resistive losses in the final perovskite modules. Optimization of the oxide thickness for single cells versus larger surface area modules may be significantly different due to the interconnection resistive loss issues. Finally, it is worth noting that although the modules based on ~10 nm TiO₂ ETL displayed good module performance, the resistance of FTO/TiO₂/Au contact, corresponding to the non-ideal case of Figure 2A, was still about a factor of two larger than that of FTO/Au (without TiO₂ to simulate complete removal of the ETL), corresponding to the ideal case of Figure 2B; this suggests that further improvement of module performance with higher FF can be expected with designs to fully address the interconnection contact issue.

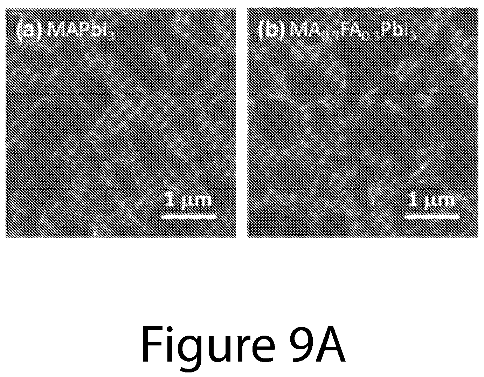

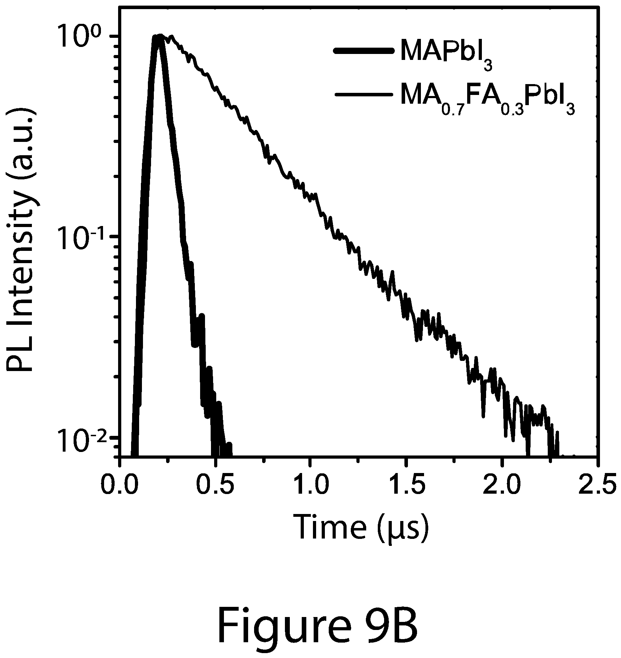

Composition engineering via A-site cation alloying (e.g., methylammonium - MA, formamidinium - FA, cesium) may improve the performance of perovskite solar cells. MA-FA alloying may result in the scalable deposition of perovskite thin films when assisted with the use of a heated substrate and the adjusting of the solvent composition may provide a wide processing window for blade coating processing method to manufacture high-quality perovskite thin films. Therefore, such solvent strategies were utilized with blade coating methods for producing mixed-cation perovskites. Panels (a) and (b) of Figure 9A compare the top view SEM images of the MAPbI₃ and MA_{0.7}FA_{0.3}PbI₃ thin films prepared by using a blade coating approach. The grain morphology looks similar and both films were compact with no pinholes, which is important to ensure high-performance perovskite solar cells. The carrier lifetime of these two types of perovskite thin films were examined by TRPL measurement. Figure 9B shows that MA_{0.7}FA_{0.3}PbI₃ has a much longer carrier lifetime than MAPbI₃ implying a reduced defect density with mixed cations.

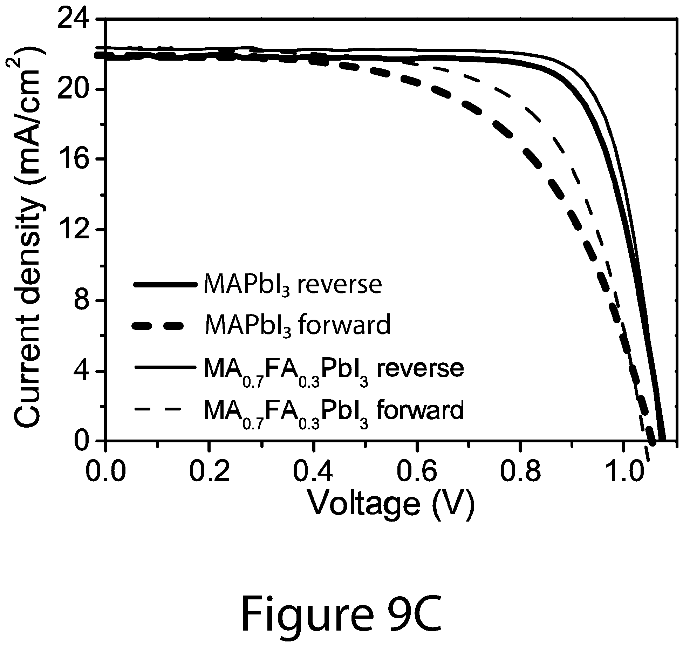

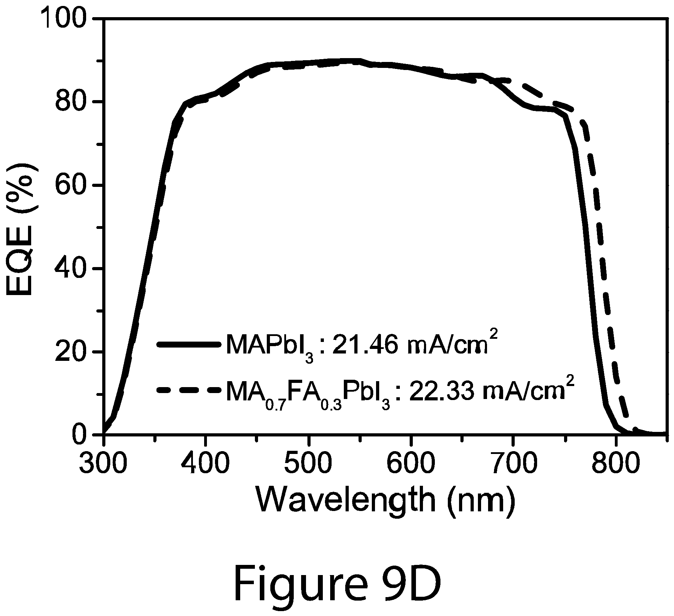

Perovskite solar cells were prepared to compare the device characteristics. The typical J-V curves and EQE spectra of lab-scale PSCs (~0.1 cm² active area) using MAPbI₃ and MA_{0.7}FA_{0.3}PbI₃ are compared in Figures 9C and 9D, respectively. In comparison to the MAPbI₃ PSC, the MA_{0.7}FA_{0.3}PbI₃ PSC shows improved PCE and reduced hysteresis. The detailed PV parameters are shown in Table 2. The PCE improvement is largely attributed to higher *J*_{sc} and FF with minimum change in *V*_{oc}. The higher *J*_{sc} for MA_{0.7}FA_{0.3}PbI₃ PSC is consistent with the improved EQE spectrum with a wider photo-response toward to the near infrared region. The long wavelength onset of EQE spectrum increases by about 16 nm when the perovskite composition was changed from MAPbI₃ to MA_{0.7}FA_{0.3}PbI₃, corresponding to about 30 meV reduction of the bandgap. Despite the smaller bandgap, the *V*_{oc} was only affected by a few mV, which is consistent with the reduced defect density observed for the MA_{0.7}FA_{0.3}PbI₃ perovskite composition shown by TRPL.

**Table 2. PV parameters of PSCs based on MAPbI₃ and MA_{0.7}FA_{0.3}PbI₃ perovskite thin films.**

| | | ***J*_{sc} (mA/cm²)** | ***V*_{oc} (V)** | **FF** | **PCE (%)** |
|---|---|---|---|---|---|
| MAPbI₃ | Reverse | 21.88 | 1.075 | 0.769 | 18.08 |
| | Forward | 21.90 | 1.054 | 0.587 | 13.56 |
| MA_{0.7}FA_{0.3}PbI₃ | Reverse | 22.34 | 1.071 | 0.792 | 18.96 |
| | Forward | 22.38 | 1.045 | 0.655 | 15.32 |

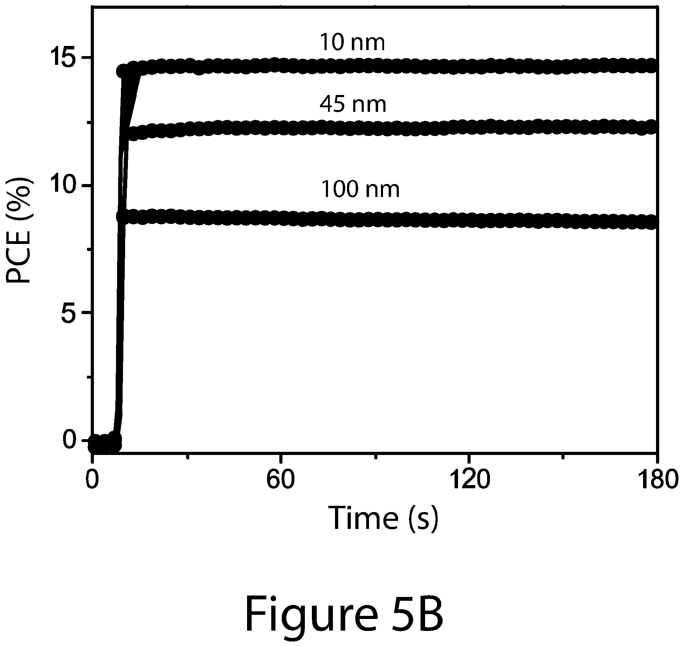

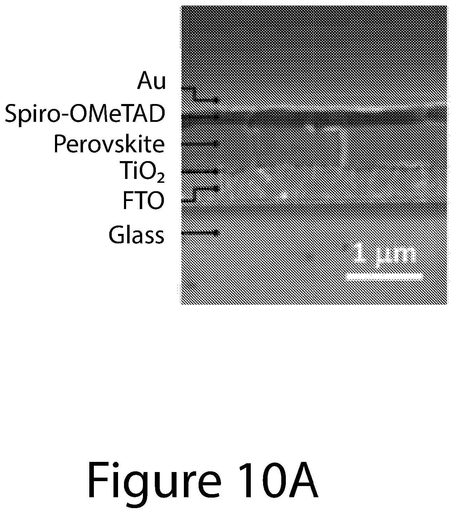

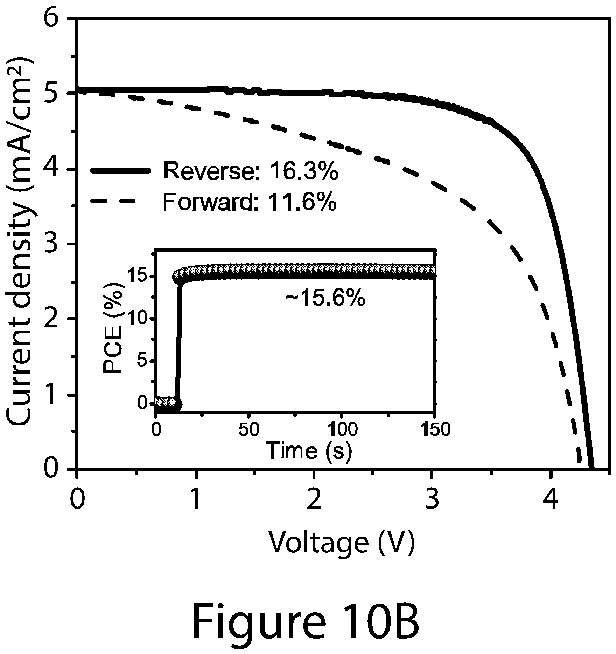

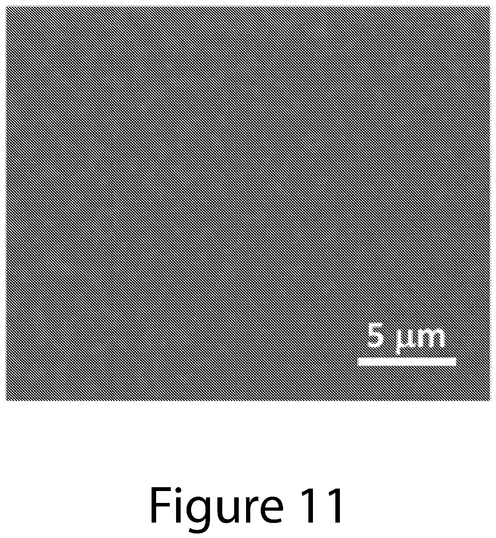

To achieve large scale production of perovskite modules, it is important to have fully scalable deposition methods for producing all device layers, including the perovskite active layer and the charge transport layers (e.g. ETL and HTL). For the PSC device structures used in this study, the TiO₂ ETL was prepared by spray pyrolysis, which is scalable and suitable for large area module fabrication. In addition, as described herein, blade coating was implemented to produce a spiro-OMeTAD HTL with a composition that is also useful for application using a spin coating process. The blade coating method using the spiro-OMeTAD composition performed well. An example of the HTL solution includes 72 mg 2,2',7,7'-tetrakis(N,N-dip-methoxyphenylamine)-9,9'-spirobifluorene (Spiro-MeOTAD; Merck), 17 µL bis(trifluoromethane) sulfonimide lithium salt stock solution (520 mg Li-TFSI in 1 mL acetonitrile), and 29 µL 4-tert-butylpyridine (TBP), 20 µL FK102 Co(III) TFSI solution (300 mg/mL in acetonitrile), and 1 mL chlorobenzene solvent. Figure 10A shows the cross-section SEM image of the full device stack consisting of spiro-OMeTAD HTL and MA_{0.7}FA_{0.3}PbI₃ perovskite layer both prepared by blade coating. The perovskite layer thickness is about 550 nm whereas the spiro-OMeTAD layer thickness is about 150-200 nm. The top view SEM image of the resultant blade-coated spiro-OMeTAD thin film is shown in Figure 11. The film is continuous and pinhole-free. Figure 10B shows the *J*-*V* curves (with both forward and reverse scans) of the best-performing four-cell perovskite module with blade coating applied perovskite layer and HTL. The aperture (~10.36 cm²) PCE from reverse scan is about 16.3% with a *J*_{sc} of ~5 mA/cm², *V*_{oc} of ~4.35 V, and FF of ~0.74. The corresponding per-cell *J*_{sc} and *V*_{oc} are ~20 mA/cm² and 1.09 V, respectively. The *V*_{oc} value is very similar to that of the small-area (~0.1 cm² active area) PSC (see Figure 9C), which confirms the high quality of both the blade-coated perovskite and spiro-OMeTAD layer over the larger-area substrate. Since the module showed clear hysteresis with forward-scan PCE of ~11.6% resulting mainly from the reduced FF (~0.54), the stabilized PCE (or SPO) under continuous one-sun illumination was also studied. The stable (aperture) PCE reached about 15.6%, which is closer to the PCE determined from the reverse-scan *J*-*V* curve. It is worth noting that this aperture SPO efficiency of 15.6% was achieved with a geometrical fill factor of about 87.3% (see Figure 5B), corresponding to an active-area module PCE of 17.9%. Since a module's GFF can be improved to >95% with modern scribing techniques, it may be expected that perovskite modules with aperture PCE >17% may also be achieved.

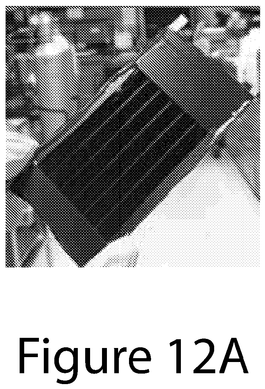

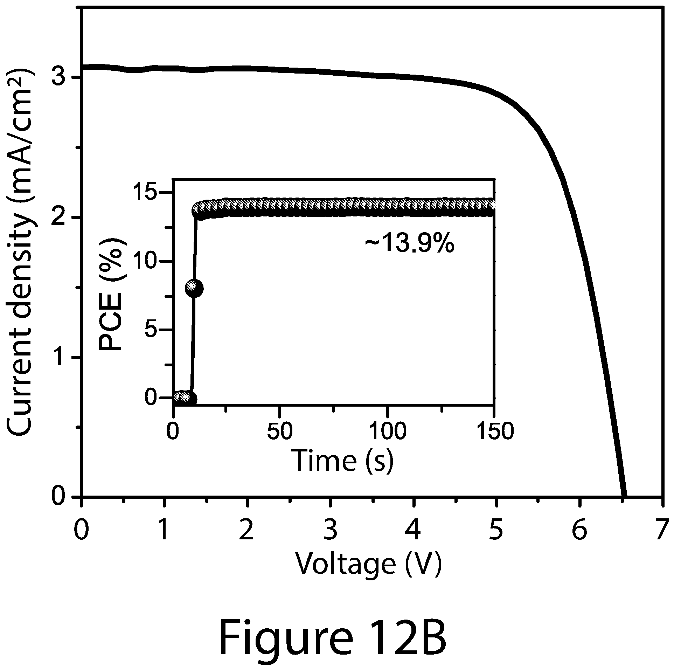

With the capability of fully scalable deposition of a perovskite-containing device stack, a six-cell module was manufactured with a ~26 cm² aperture area, produced by blade coating of both the perovskite layer and HTL (see Figure 12A.) This further demonstrates the feasibility of the scalable deposition techniques demonstrated herein for producing larger scale perovskite solar modules. This six-cell module shows an aperture PCE of ~14.6% from reverse *J*-*V* scan (with *J*_{sc} of 3.07 mA/cm², *V*_{oc} of 6.54 V, and FF of 0.73) and the aperture SPO efficiency of ~13.9% under continuous one-sun illumination (see Figure 12B). The relatively low aperture SPO is in part caused a smaller GFF (~83%) for this 26-cm² 6-cell perovskite module, corresponding to an active-area PCE of about 16.7%, which further confirms that blade coating of both the perovskite layer and the spiro-OMeTAD HTL is suitable for large scale perovskite module development.

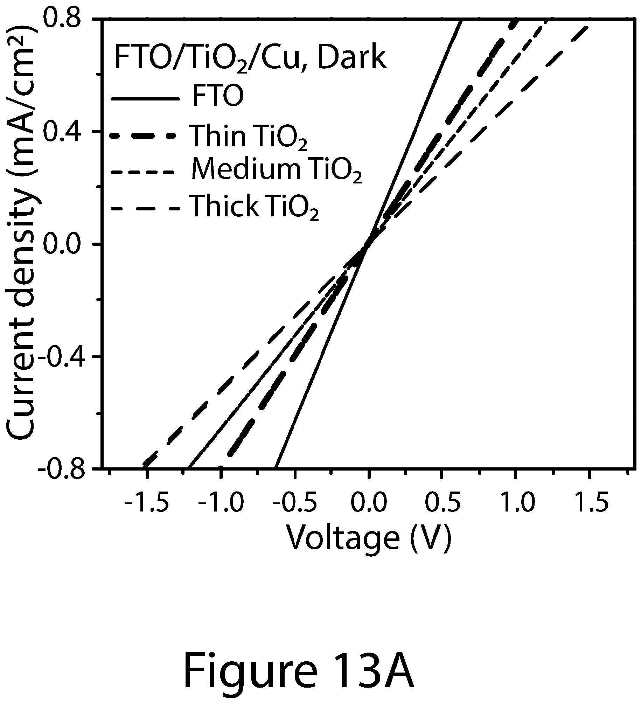

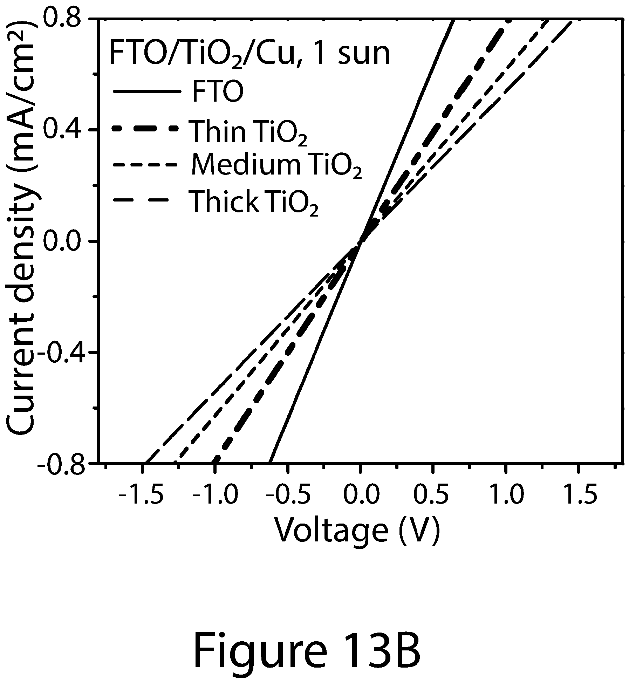

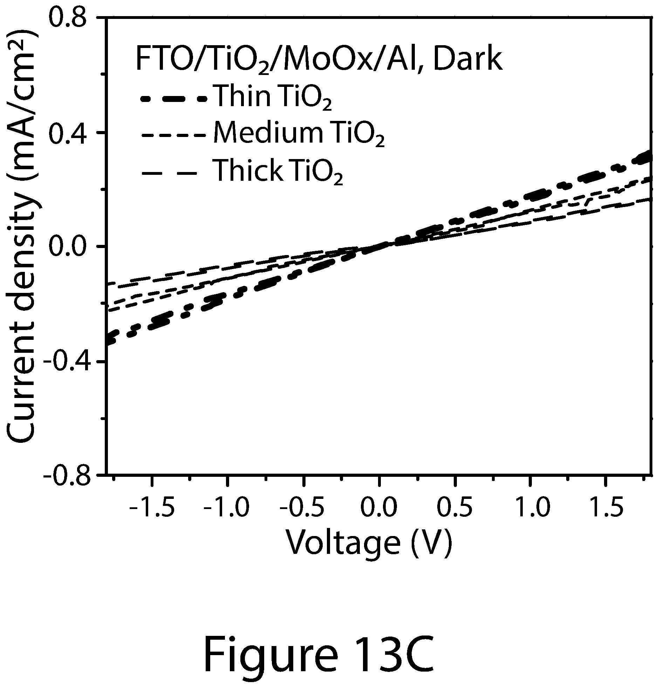

The impact of other second contact layer materials on the contact characteristics was also evaluated, with the results summarized in Figures 13A, 13B, and 13C. Interestingly, referring to Figures 13A and 13B, when copper was used to replace gold as the second contact layer material, the second contact layer demonstrated ohmic behavior regardless of the thickness of the underlying TiO₂ ETL. The resistance was also much reduced in comparison to the Au/TiO₂ (contact layer/ETL) combination. Also, the Cu/TiO₂ (contact layer/ETL) combination exhibited very minimum dependence on the illumination condition. Figure 13C illustrates the contact behavior of FTO/TiO₂/MoOₓ/Al. Although the FTO/TiO₂/MoOₓ/Al also demonstrated ohmic contact behavior, the resistance was significantly larger than the silver and copper contacts layers.

As used herein, the term "substantially" refers to the inherent error involved in any numerical measurement. For example, a gap extending substantially through a thickness of layer refers to a gap that extends exactly through the thickness, a gap that extends almost entirely through the thickness, and a gap that extends entirely through the thickness and into the underlying substrate. The exact depth of the gap for the second and third cases will depend on the method used for forming the gap, e.g. laser scribing, mechanical scribing, and/or chemical etching, and are known to one of ordinary skill in the art of scribing photovoltaic materials and surfaces.

### Experimental:

***Organic-Inorganic Halide Perovskite film deposition.*** For blade coating, 42 wt% equimolar ratio MAI and PbI₂ precursors with 20% MACl additive in mixed solvent (NMP/DMF 55/45 weight ratio) were used. For mixed cations, 30% (molar ratio) FAI and 70% (molar ratio) MAI was used to replace MAI, and mixed solvent was adjusted to a higher DMF ratio (NMP/DMF 30/70 weight ratio). Blade coating was performed on a Zehntner-Automatic film applicator coater using Zehntner ZUA 2000 blade at room temperature inside a N₂-filled glovebox. The gap between blade and top substrate was fixed at 130 µm and the speed of coating was 5 mm/s. Once the precursor ink was dispensed on to the substrate by blade coating, the substrate was transferred into diethyl ether bath after about one minute of drying. Perovskite film crystalized in ether bath in 1 minute. A further thermal annealing was conducted after the bath at 150°C with petri-dish covered for 75 seconds.

***Device fabrication.*** For small area devices, a fluorine-doped tin oxide (FTO) substrate (TEC 7, Hartford Glass Co) was patterned using hydrogen evolution etching method (zinc powder and 5M HCl solution). For larger surface area modules (MMs), 1.5"×2" TEC 7 substrates were laser-scribed (532 nm) with 7 mm spacing. Pre-patterned FTO was cleaned in base bath (0.2 M NaOH in ethanol) and then deposited with compact TiO₂ (c-TiO₂) layers of various thickness by spray pyrolysis using 0.2 M titanium diisopropoxide bis(acetylacetonate) in a 1-butanol solution at 450°C. The thickness of TiO₂ was controlled by the amount of sprayed solvent. Sprayed film was annealed at 450°C for 1 hour. A thin C60 layer was deposited on the top of c-TiO₂. The concentrations of C60 SAM (1-material) were 1-1.5 mg/ml in mixed solvent (chlorobenzene/tetrahydrofuran=1/1 volume ratio). Blade coating was done with 2.5 mm/s speed with 130 µm gap and spin coating was done are 4000 rpm for 30 seconds. The perovskite film was subsequently coated before the deposition of the hole transport layer (HTL). The HTL solution was composed of 72 mg 2,2',7,7'-tetrakis(N,N-dip-methoxyphenylamine)-9,9'-spirobifluorene (Spiro-MeOTAD; Merck), 17 µL bis(trifluoromethane) sulfonimide lithium salt stock solution (520 mg Li-TFSI in 1 mL acetonitrile), and 29 µL 4-tert-butylpyridine (TBP), 20 µL FK102 Co(III) TFSI solution (300 mg/mL in acetonitrile), and 1 mL chlorobenzene solvent. HTL was spin coated at 4,000 rpm for 35 seconds or blade coated at 130 µm gap with 10 mm/s speed. For MMs, the P2 gaps were scribed next to the P1 gaps using a mechanical scriber. A 100-nm Au layer was deposited on the HTL layer by thermal evaporation for top contact. For MMs, the P3 gaps were further performed next to the P2 gaps to isolate top contacts. Edges of MMs were further deleted, and copper foil tape was attached for external wiring.

***Film characterizations.*** X-ray diffraction (XRD) of the perovskite thin films was performed using an X-ray diffractometer (Rigaku D/Max 2200) with Cu K_{α} radiation. Absorption spectra were carried out by an ultraviolet-visible (UV/Vis) spectrometer (Cary-6000i). SEM was taken by NOVA 630 NanoSEM, FEI. Contact resistance measurement was conducted on FTO/c-TiO₂/Au sandwiched structure using Keithley Source Meter (Model 2400) under one-sun condition.

***Device characterizations.*** The *J-V* characteristics of the cells were obtained by using a Keithley Source Meter (Model 2400) under simulated one-sun AM 1.5G illumination at 100 mW cm⁻² (Oriel Sol3A Class AAA Solar Simulator, Newport Corporation). A non-reflective shadow mask was used to define active area (0.12 cm² for small area and 10.36 cm² for MMs unless otherwise stated). External quantum efficiency (EQE) was measured using a solar cell quantum efficiency measurement system (QEX10, PV Measurements). Stabilized power output was monitored by a potentiostat (VersaSTAT MC, Princeton Applied Research) near a maximum power output point.

## Claims

1. A perovskite (100) -containing solar cell module (200) comprising:
a substrate (210) having a first surface;
a first cell (202A); and
a second cell (202B), wherein:
each cell comprises, in order:
a first contact layer (220) comprising a first material, positioned on the substrate (210), and having a second surface and a first thickness;
an electron transfer layer (ETL) (230) comprising a second material and having a second thickness;
an active layer comprising the perovskite (100) and having a third thickness;
a hole transfer layer (HTL) (250) comprising a third material and having a fourth thickness; and
a second contact layer (260) comprising a fourth material and having a fifth thickness,
wherein:
the first cell (202A) and the second cell (202B) are electrically connected by a first gap (315) filled with the fourth material, and
the first gap (315) passes through the active layer, the HTL (250), and substantially through the ETL (230) to terminate at the second surface;
and **characterised in that** the second thickness of the ETL is 1 nm - 45 nm.

2. The solar cell module (200) of claim 1, further comprising:
a second gap (345) filled with the second material, wherein:
the second gap (345) passes substantially through the first contact layer (220) to terminate at the first surface, and
the second gap (345) separates the first contact layer (220) of the first cell (202A) from the first contact layer (220) of the second cell (202B).

3. The solar cell module (200) of either claim 1 or claim 2, further comprising:
a third gap (355), wherein
the third gap (355) passes through the HTL (250), the active layer, and substantially through the ETL (230) to terminate at the second surface, and
the third gap (355) separates the second contact layer (260) of the first cell (202A) from the second contact layer (260) of the second cell (202B).

4. The solar cell module (200) of any one of claims 1-3, further comprising:
an insulating layer comprising a fifth material and positioned on the second contact layer (260), wherein:
the second contact layer (260) is positioned between the insulating layer and the HTL (250),
the insulating layer is not electrically conductive, and
the fifth material fills the third gap (355).

5. The solar cell module (200) of any one of claims 1-4, wherein:
the perovskite (100) is defined by ABX₃,
A is a first cation (110),
B is a second cation (120), and
X is an anion (130).

6. The solar cell module (200) of any one of claims 1-5, wherein the perovskite (100) comprises at least one of MAPbl₃ or MAₓFA₁₋ₓPbl₃, wherein x is between zero and one, inclusively.

7. The solar cell module (200) of claim 1, wherein the first material comprises at least one of a metal nanowire, a carbon nanotube, a transparent conducting oxide, graphene, or PEDOT:PSS.

8. The solar cell module (200) of any one of claims 1-7, wherein the second material comprises at least one of TiO₂, ZnO, SnO₂, BaSnO₃, or SrTiO₃.

9. The solar cell module (200) of any one of claims 1-8, wherein:
the ETL (230) further comprises a compact layer and a mesoporous layer, and
the compact layer is positioned between the mesoporous layer and the first contact layer (220).

10. The solar cell module (200) of any one of claims 1-9, wherein the third material comprises at least one of spiro-OMeTAD, PTAA, NiO, CuSCN, CuPc, Cul, a graphene oxide, a carbon nanotube, or any suitable organic material.

11. The solar cell module (200) of any one of claims 1-10, wherein the fourth material comprises at least one of gold, silver, copper, aluminum, nickel, chromium, a molybdenum oxide, a carbon nanotube, graphene, or a transparent conducting oxide.

12. The solar cell module (200) of any one of claims 1-11, wherein the second contact layer (260) has a thickness between 1 nm and 10 µm.

## Patentansprüche

1. Perowskit (100) enthaltendes Solarzellenmodul (200), umfassend:
ein Substrat (210), das eine erste Oberfläche aufweist;
eine erste Zelle (202A); und
eine zweite Zelle (202B), wobei:
jede Zelle in dieser Reihenfolge Folgendes umfasst:
eine erste Kontaktschicht (220), umfassend ein erstes Material, das auf dem Substrat (210) positioniert ist, und eine zweite Oberfläche und eine erste Stärke aufweist;
eine Elektronenübertragungsschicht (ETL) (230), umfassend ein zweites Material und die eine zweite Stärke aufweist;
eine aktive Schicht, umfassend den Perowskit (100) und die eine dritte Stärke aufweist;
eine Lochübertragungsschicht (HTL) (250), umfassend ein drittes Material und das eine vierte Stärke aufweist; und
eine zweite Kontaktschicht (260), umfassend ein viertes Material und das eine fünfte Stärke aufweist,
wobei:
die erste Zelle (202A) und die zweite Zelle (202B) durch eine erste Lücke (315), die mit dem vierten Material gefüllt ist, elektrisch verbunden sind, und
die erste Lücke (315) durch die aktive Schicht, die HTL (250) und im Wesentlichen durch die ETL (230) verläuft, um an der zweiten Oberfläche zu enden;
und **dadurch gekennzeichnet, dass** die zweite Stärke der ETL 1 nm - 45 nm ist.

2. Solarzellenmodul (200) nach Anspruch 1, ferner umfassend:
eine zweite Lücke (345), die mit dem zweiten Material gefüllt ist, wobei:
die zweite Lücke (345) im Wesentlichen durch die erste Kontaktschicht (220) verläuft, um an der ersten Oberfläche zu enden, und
die zweite Lücke (345) die erste Kontaktschicht (220) der ersten Zelle (202A) von der ersten Kontaktschicht (220) der zweiten Zelle (202B) trennt.

3. Solarzellenmodul (200) nach Anspruch 1 oder Anspruch 2, ferner umfassend:
eine dritte Lücke (355), wobei
die dritte Lücke (355) durch die HTL (250), die aktive Schicht und im Wesentlichen durch die ETL (230) verläuft, um an der zweiten Oberfläche zu enden, und
die dritte Lücke (355) die zweite Kontaktschicht (260) der ersten Zelle (202A) von der zweiten Kontaktschicht (260) der zweiten Zelle (202B) trennt.

4. Solarzellenmodul (200) nach einem der Ansprüche 1-3, ferner umfassend:
eine Isolierschicht, umfassend ein fünftes Material und die auf der zweiten Kontaktschicht (260) positioniert ist, wobei:
die zweite Kontaktschicht (260) zwischen der Isolierschicht und der HTL (250) positioniert ist,
die Isolierschicht elektrisch nicht leitend ist, und
das fünfte Material die dritte Lücke (355) füllt.

5. Solarzellenmodul (200) nach einem der Ansprüche 1-4, wobei:
der Perowskit (100) durch ABX₃ definiert ist,
A ein erstes Kation (110) ist,
B ein zweites Kation (120) ist, und
X ein Anion (130) ist.

6. Solarzellenmodul (200) nach einem der Ansprüche 1-5, wobei der Perowskit (100) mindestens eines von MAPbI₃ oder MAₓFA₁₋ₓPbI₃ umfasst, wobei x einschließlich zwischen null und eins ist.

7. Solarzellenmodul (200) nach Anspruch 1, wobei das erste Material mindestens eines von einem Metall-Nanodraht, einem Kohlenstoff-Nanoröhrchen, einem transparenten leitenden Oxid, Graphen oder PEDOT:PSS umfasst.

8. Solarzellenmodul (200) nach einem der Ansprüche 1-7, wobei das zweite Material mindestens eines von TiO₂, ZnO, SnO₂, BaSnO₃ oder SrTiO₃ umfasst.

9. Solarzellenmodul (200) nach einem der Ansprüche 1-8, wobei:
die ETL (230) ferner eine kompakte Schicht und eine mesoporöse Schicht umfasst, und
die kompakte Schicht zwischen der mesoporösen Schicht und der ersten Kontaktschicht (220) positioniert ist.

10. Solarzellenmodul (200) nach einem der Ansprüche 1-9, wobei das dritte Material mindestens eines von Spiro-OMeTAD, PTAA, NiO, CuSCN, CuPc, CuI, einem Graphenoxid, einem Kohlenstoffnanoröhrchen oder einem beliebigen geeigneten organischen Material umfasst.

11. Solarzellenmodul (200) nach einem der Ansprüche 1-10, wobei das vierte Material mindestens eines von Gold, Silber, Kupfer, Aluminium, Nickel, Chrom, einem Molybdänoxid, einem Kohlenstoffnanoröhrchen, Graphen oder einem transparenten leitenden Oxid umfasst.

12. Solarzellenmodul (200) nach einem der Ansprüche 1-11, wobei die zweite Kontaktschicht (260) eine Stärke zwischen 1 nm und 10 µm aufweist.

## Revendications

1. Module de cellule solaire (200) contenant de la pérovskite (100) comprenant :
un substrat (210) comportant une première surface ;
une première cellule (202A) ; et
une seconde cellule (202B), dans lequel :
chaque cellule comprend, dans l'ordre :
une première couche de contact (220) comprenant un premier matériau, positionnée sur le substrat (210), et comportant une seconde surface et une première épaisseur ;
une couche de transfert d'électrons (ETL) (230) comprenant un deuxième matériau et comportant une deuxième épaisseur ;
une couche active comprenant la pérovskite (100) et comportant une troisième épaisseur ;
une couche de transfert de trous (HTL) (250) comprenant un troisième matériau et comportant une quatrième épaisseur ; et
une seconde couche de contact (260) comprenant un quatrième matériau et comportant une cinquième épaisseur,
dans lequel :
la première cellule (202A) et la seconde cellule (202B) sont raccordées électriquement par un premier espace (315) rempli du quatrième matériau, et
le premier espace (315) traverse la couche active, la HTL (250), et sensiblement l'ETL (230) pour se terminer au niveau de la seconde surface ;
et **caractérisé en ce que** la deuxième épaisseur de l'ETL est de 1 nm à 45 nm.

2. Module de cellule solaire (200) de la revendication 1, comprenant en outre :
un deuxième espace (345) rempli du deuxième matériau, dans lequel :
le deuxième espace (345) traverse sensiblement la première couche de contact (220) pour se terminer au niveau de la première surface, et
le deuxième espace (345) sépare la première couche de contact (220) de la première cellule (202A) par rapport à la première couche de contact (220) de la seconde cellule (202B).

3. Module de cellule solaire (200) de la revendication 1 ou de la revendication 2, comprenant en outre :
un troisième espace (355), dans lequel
le troisième espace (355) traverse la HTL (250), la couche active, et sensiblement l'ETL (230) pour se terminer au niveau de la seconde surface, et
le troisième espace (355) sépare la seconde couche de contact (260) de la première cellule (202A) par rapport à la seconde couche de contact (260) de la seconde cellule (202B).

4. Module de cellule solaire (200) de l'une quelconque des revendications 1 à 3, comprenant en outre :
une couche isolante comprenant un cinquième matériau et positionnée sur la seconde couche de contact (260), dans lequel :
la seconde couche de contact (260) est positionnée entre la couche isolante et la HTL (250),
la couche isolante n'est pas conductrice d'électricité, et
le cinquième matériau remplit le troisième espace (355).

5. Module de cellule solaire (200) de l'une quelconque des revendications 1 à 4, dans lequel :
la perovskite (100) est définie par ABX₃,
A est un premier cation (110),
B est un second cation (120), et
X est un anion (130).

6. Module de cellule solaire (200) de l'une quelconque des revendications 1 à 5, dans lequel la pérovskite (100) comprend au moins l'un parmi MAPbI₃ ou MAₓFA₁₋ₓPbI₃, dans lequel x est compris entre zéro et un, inclusivement.

7. Module de cellule solaire (200) de la revendication 1, dans lequel le premier matériau comprend au moins l'un parmi un nanofil métallique, un nanotube de carbone, un oxyde conducteur transparent, le graphène ou le PEDOT:PSS.

8. Module de cellule solaire (200) de l'une quelconque des revendications 1 à 7, dans lequel le deuxième matériau comprend au moins l'un parmi le TiO₂, le ZnO, le SnO₂, le BaSnO₃ ou le SrTiO₃.

9. Module de cellule solaire (200) de l'une quelconque des revendications 1 à 8, dans lequel :
l'ETL (230) comprend en outre une couche compacte et une couche mésoporeuse, et
la couche compacte est positionnée entre la couche mésoporeuse et la première couche de contact (220).

10. Module de cellule solaire (200) de l'une quelconque des revendications 1 à 9, dans lequel le troisième matériau comprend au moins l'un parmi le spiro-OMeTAD, le PTAA, le NiO, le CuSCN, le CuPc, le CuI, un oxyde de graphène, un nanotube de carbone ou tout matériau organique approprié.

11. Module de cellule solaire (200) de l'une quelconque des revendications 1 à 10, dans lequel le quatrième matériau comprend au moins l'un parmi l'or, l'argent, le cuivre, l'aluminium, le nickel, le chrome, un oxyde de molybdène, un nanotube de carbone, le graphène ou un oxyde conducteur transparent.

12. Module de cellule solaire (200) de l'une quelconque des revendications 1 à 11, dans lequel la seconde couche de contact (260) comporte une épaisseur comprise entre 1 nm et 10 µm.
